(19) **Europäisches Patentamt / European Patent Office / Office européen des brevets**

(11) **EP 3 646 674 B1**

(12) **EUROPÄISCHE PATENTSCHRIFT**

(45) Veröffentlichungstag und Bekanntmachung des Hinweises auf die Patenterteilung:
**23.10.2024   Patentblatt 2024/43**

(21) Anmeldenummer: **18742735.6**

(22) Anmeldetag: **09.07.2018**

(51) Internationale Patentklassifikation (IPC):
**H05B 45/24** (2020.01)         **G01R 19/00** (2006.01)
**G01R 31/44** (2020.01)

(52) Gemeinsame Patentklassifikation (CPC):
**G01R 19/0092; H05B 45/24;** G01R 19/0023;
G01R 31/44

(86) Internationale Anmeldenummer:
**PCT/EP2018/068573**

(87) Internationale Veröffentlichungsnummer:
**WO 2019/020357 (31.01.2019 Gazette 2019/05)**

(54) **SCHALTUNGSANORDNUNG UND VERFAHREN ZUR ERMITTLUNG EINES EINEN STROMISTWERT REPRÄSENTIERENDEN SIGNALS**

CIRCUIT ARRANGEMENT AND METHOD FOR DETERMINING A SIGNAL REPRESENTING AN ACTUAL CURRENT VALUE

CIRCUIT ET MÉTHODE POUR ÉVALUER UN SIGNAL REPRÉSENTANT UNE VALEUR ACTUELLE DE COURANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.07.2017   DE 102017212822**
**08.09.2017   AT 19717 U**
**20.03.2018   DE 102018204240**

(43) Veröffentlichungstag der Anmeldung:
**06.05.2020   Patentblatt 2020/19**

(73) Patentinhaber: **Tridonic GmbH & Co KG**
**6851 Dornbirn (AT)**

(72) Erfinder:
- **GSTIR, Sascha**
  **6923 Lauterach (AT)**
- **KUCERA, Clemens**
  **6700 Bludenz (AT)**
- **LOCHMANN, Frank**
  **88147 Achberg (DE)**
- **MARTE, Patrick**
  **6840 Götzis (AT)**
- **MAYRHOFER, Markus**
  **6850 Dornbirn (AT)**

- **NESENSOHN, Christian**
  **6840 Götzis (AT)**
- **NETZER, Harald**
  **6710 Nenzing (AT)**
- **WYNNYCZENKO, Oliver**
  **6890 Lustenau (AT)**

(74) Vertreter: **Beder, Jens**
**Mitscherlich PartmbB**
**Patent- und Rechtsanwälte**
**Karlstraße 7**
**80333 München (DE)**

(56) Entgegenhaltungen:
**US-A1- 2005 134 490       US-A1- 2005 134 490**
**US-A1- 2007 152 864       US-A1- 2007 152 864**
**US-A1- 2013 027 022       US-A1- 2013 027 022**
**US-B2- 7 573 209          US-B2- 7 573 209**

- **LEI SUN: "High Performance SAR-based ADC Design in Deep Sub-micron CMOS", 1 January 2013 (2013-01-01), pages 781 - 329, XP055518322, ISBN: 978-1-303-84540-6, Retrieved from the Internet <URL:https://www.analog.com/media/en/technical-documentation/datasheets/ad7264.pdf> [retrieved on 20181106]**

**Beschreibung**

Die Erfindung ist auf dem Gebiet der Betriebsgeräte für Leuchtmittel, insbesondere für Leuchtdioden.

Die Erfindung betrifft insbesondere eine Schaltungsanordnung zur Ermittlung eines Stromistwerts, sowie ein entsprechendes Verfahren und eine Steuervorrichtung. Es wird eine Schaltungsanordnung vorgeschlagen, die eine präzise Ermittlung des Stroms über einen großen Dynamikbereich mit einem kontinuierlichen Übergang zwischen Strommessbereichen ermöglicht. Weiter ist ein Betriebsgerät für Leuchtmittel mit einer entsprechenden Ermittlung des Stroms und einer entsprechenden Steuerung des Laststroms über die Leuchtmittel umfasst.

Sowohl die Farbtemperatur als auch die Beleuchtungsstärke künstlich, insbesondere mit Leuchtdioden (LED), erzeugten Lichts haben großen Einfluss auf das Wohlempfinden eines Nutzers. Auch können über geeignet ausgelegte Beleuchtungslösungen Konzentration und Produktivität in Büroräumen, eine produktspezifische und saisonal angepasste Beleuchtung in Verkaufsräumen oder eine therapeutische Unterstützung in Verkaufsräumen erzielt werden.

In der Beleuchtungstechnik werden daher beispielsweise Leuchten eingesetzt, die das Tageslicht nachzubilden vermögen und sich individuellen Bedürfnissen des Nutzers anpassen.

Die Farbtemperatur des abgegebenen Lichts der Leuchte ist hierzu einstellbar. Dies kann mittels zweier Lichtkanäle, einem Kanal der ein kaltweißes Licht abgibt, sowie einem weiteren Kanal, der ein warmweißes Licht abgibt, wobei die beiden Kanäle individuell ansteuerbar sind, erreicht werden. Als lichtemittierende Elemente werden in beiden Kanälen typisch Leuchtdioden (LED) verwendet.

Die Beleuchtungsstärke des abgegebenen Lichts ist für entsprechende Beleuchtungslösungen in einem Bereich von typisch 10% oder 15% bis hin zu 100% zu dimmen.

Um die Beleuchtungsstärke des abgegebenen Lichts über einen weiten Bereich steuern zu können (Dimmen) und zugleich eine hochgenaue Farbtemperatur des abgegebenen Lichts beizubehalten, ist eine hochgenaue Ermittlung eines elektrischen Stroms über die LEDs erforderlich, um die Leuchte, insbesondere einen den jeweiligen LED-Strom erzeugenden Konverterschaltkreis entsprechend regeln zu können. Zugleich werden für entsprechende Beleuchtungslösungen Konverter in großen Stückzahlen benötigt und stellen somit einen wesentlichen Kostenfaktor dar.

US 2013/027022 A1 offenbart ein System zum Messen von Strom umfassend ein Stromüberwachungssystem mit einem Stromsensor. Der Stromsensor ist so konfiguriert, dass er einen ersten Strom erfasst, der durch einen Leiter fließt. Das Stromüberwachungssystem umfasst ferner eine Spannungsumwandlungsvorrichtung, die mit dem Stromsensor gekoppelt ist, und so konfiguriert ist, dass sie einen zweiten Strom von dem Stromsensor empfängt und den zweiten Strom in eine erste Spannung wandelt. Eine erste Skalierungsschaltung ist mit der Spannungsumwandlungsvorrichtung gekoppelt und so ausgelegt, dass sie die erste Spannung auf der Grundlage eines ersten Skalierungsfaktors in eine zweite Spannung umwandelt, die proportional zu dem ersten Strom ist. Eine zweite Skalierungsschaltung ist mit der Spannungsumwandlungsvorrichtung gekoppelt und so ausgelegt, dass sie die erste Spannung auf der Grundlage eines zweiten Skalierungsfaktors in eine dritte Spannung umwandelt, die proportional zu dem ersten Strom ist, wobei sich der zweite Skalierungsfaktor von dem ersten Skalierungsfaktor unterscheidet.

US 7 573 209 B2 zeigt ein Verfahren und ein System zur Steuerung der Chromatizität und des Lichtstroms einer digital gesteuerten Leuchte. Die Leuchte umfasst ein oder mehrere lichtemittierende Elemente und einen oder mehrere Lichtsensoren, die ein optisches Feedback liefern können, wobei dieses optische Feedback gefiltert wird, um unerwünschte Frequenzen zu entfernen. Das Verfahren und System umfasst ein Steuersystem, das die gefilterten Signale von den Lichtsensoren gemäß einem vorbestimmten Rückkopplungsabtastfrequenzschema abtasten kann, wobei dieses Schema spezifisch konfiguriert ist, um ausreichende Iterationen der Rückkopplungsschleife bereitzustellen, die zur Einstellung der Farb- und Lichtstromausgabe der lichtemittierenden Elemente ohne wahrnehmbares visuelles Flimmern oder momentane Farbverschiebungen durchgeführt werden.

US 2005/134490 A1 offenbart ein Messgerät für Stromleitungen, das erste Eingangskanäle für Wechselstromsignalen mit Gleichstromwerten von etwa Null aufweist. Ein zweiter Eingangskanal verfügt über einen analogen Ausgang mit einem vorgegebenen DC-Bias-Wert ungleich Null. Mehrere Vorspannungs- und Skalierungsschaltungen geben die Wechselstromsignale ein und geben entsprechende analoge Ausgänge aus. Mehrere Analog-Digital-Wandler erhalten die entsprechenden analogen Signale und geben entsprechende digitale Werte aus. Eine serielle Ausgangsschaltung übermittelt seriell die entsprechenden digitalen Werte für einen ersten Satz von A/D-Wandlungen, bevor seriell digitale Werte für einen nachfolgenden zweiten Satz von Wandlungen übermittelt werden, ohne eine Synchronisierung der entsprechenden digitalen Werte sowohl für den ersten als auch für den zweiten Satz von Wandlungen bereitzustellen. Eine serielle Eingangsschaltung empfängt seriell die seriell übermittelten digitalen Werte und speichert diese in einem Speicher. Ein Prozessor mittelt die digitalen Werte für die Kanäle und bestimmt, ob nur der dem zweiten Kanal zugeordnete Durchschnitt den DC-Bias-Wert aufweist.

US 2007/152864 A1 offenbart einen optischen Empfänger zur Erzeugung eines einen Stromistwert repräsentierenden Signals mit einen ersten und einen zweiten Strommesspfad. Die Signale beider Strommesspfade werden Analog-Digital-Wandlern zugeführt, und ein Controller ist so konfiguriert, dass er auf der Grundlage des Vergleichs des Signalwerts mit einem vorgegebenen Schwellenwert zwischen den digitalen Signalen der ersten oder zweiten Strommesspfaden auswählt.

Es ist also die technische Aufgabenstellung zu lösen, genaue und zugleich effizient implementierbare Vorrichtungen und Verfahren für die exakte Ermittlung eines elektrischen Stroms und eine genaue Steuerung des Ausgangsstroms eines Betriebsgeräts zu finden.

Ein erster Aspekt der Erfindung ist in Anspruch 1 definiert. Ein zweiter Aspekt der Erfindung ist in dem korrespondierenden Verfahrensanspruch definiert.

Die erfindungsgemäße Schaltungsanordnung zur Erzeugung eines einen Stromistwert repräsentierenden Signals nach Anspruch 1 umfasst: Erfassungsmittel zum Erfassen einer für den Strom repräsentativen Messgröße, einen ersten Strommesspfad mit einem ersten Verstärkerschaltkreis zur Verstärkung der erfassten Messgröße mit einem ersten Verstärkungsfaktor, einen zweiten Strommesspfad mit einem zweiten Verstärkerschaltkreis zur Verstärkung der erfassten Messgröße mit einem zweiten von dem ersten Verstärkungsfaktor verschiedenen Verstärkungsfaktor, Kombinationsmittel ausgelegt für die Erzeugung eines kombinierten Signals und Ausgabemittel für die Ausgabe des kombinierten Signals des Stromistwerts. Die Schaltungsanordnung zeichnet sich dadurch aus, dass das Kombinationsmittel ausgelegt ist, das kombinierte Signal als eine gewichtete Kombination der ersten verstärkten Messgröße mit der zweiten verstärkten Messgröße mit einer Gewichtungsfunktion für die gewichtete Kombination der ersten verstärkten Messgröße mit der zweiten verstärkten Messgröße zu erzeugen, wobei die Gewichtungsfunktion entsprechend einem Stromwert Gewichtungsfaktoren für den ersten und den zweiten Strommesspfad vorgibt. Der Stromwert ist ein Sollwert für den zu ermittelnden Strom oder ein Dimmwert. Das Kombinationsmittel ist eingerichtet, für Stromwerte kleiner als ein erster Schwellenwert allein die mit dem ersten Verstärkungsfaktor verstärkte Messgröße zu verwenden, wobei der zweite Verstärkungsfaktor kleiner als der erste Verstärkungsfaktor ist.. Das kombinierte Signal kann entweder direkt weiterverwendet werden, da es eindeutig den Strom widerspiegelt. Andererseits kann auch der Strom aus dem kombinierten Signal ermittelt werden und diese Größe dann für die weitere Verarbeitung herangezogen werden. Eine den zu messenden Strom direkt repräsentierende Größe liegt erfindungsgemäß in zwei unterschiedlich verstärkten Fassungen vor. Die durch unterschiedliche Verstärkung der Messgröße erhaltenen Signale werden anschließend gewichtet miteinander kombiniert, beispielsweise jeweils multipliziert mit jeweiligen Gewichtungsfaktoren miteinander addiert.

Damit kann die Messgröße entsprechend der jeweiligen Größe eines Stromwerts des zu ermittelnden elektrischen Stroms in einem weiten Bereich an möglichen Stromwerten, also über einen großen Dynamikbereich, genau erfassen und verarbeiten. Das erfindungsgemäße Vorgehen zur Stromermittlung zeichnet sich also durch eine inhärent hohe Genauigkeit der Strommessung über einen hohen Dynamikbereich aus. Im einfachsten Fall erfolgt eine Teilung des gesamten Bereichs in zwei Teilbereiche, wobei beim Übergang von einem Bereich zum anderen Bereich sprungartig zwischen den Messpfaden gewechselt wird.

Das erzeugte Signal ist für den Stromistwert repräsentativ, d.h. aus dem Signalwert kann eindeutig der zu ermittelnde Stromistwert bestimmt werden.

Somit kann beispielsweise eine Regelung eines kaltweißen und eines warmweißen Kanals einer abstimmbaren Weißlichtleuchte unter Nutzung der erfindungsgemäßen Schaltungsanordnung zur Strommessung über einen weiten Dimmbereich mit hoher Anforderung an eine konstante Farbtemperatur erfolgen.

Die Schaltungsanordnung umfasst das Kombinationsmittel dafür ausgelegt, eine Gewichtungsfunktion für die gewichtete Kombination der ersten verstärkten Messgröße mit der zweiten verstärkten Messgröße zu verwenden.

Die Gewichtungsfunktion wird damit entsprechend einem zu erwartenden Stromwert einstellbar und ein Messbereich mit einer zugeordneten Messgenauigkeit kann entsprechend einem zu erwartenden Messwert für den Strom eingestellt werden.

Die Schaltungsanordnung ist dadurch gekennzeichnet, dass die Gewichtungsfunktion entsprechend einem Stromwert die Gewichtungsfaktoren für den jeweiligen Strommesspfad vorgibt, wobei der Stromwert ein Sollwert für den zu messenden Strom oder ein Dimmwert ist.

Mit einem Sollwert für den zu ermittelnden Strom, insbesondere als Führungsgröße einer Regelschleife zur Regelung des Stroms, oder einem vorgegebenen Stromwert für den zu ermittelnden Strom, liegt eine Information über den erwarteten Messwert für den Strom vor, der für die Vorgabe und Auswahl einer Gewichtungsfunktion und damit für einen zu wählenden Messbereich der Schaltungsanordnung zur Strommessung wesentliche Information umfasst. Die Messung bzw. Ermittlung des Stroms auf Basis des kombinierten Signals kann dementsprechend genau erfolgen.

Die Schaltungsanordnung weist das Kombinationsmittel dafür ausgelegt auf, für Stromwerte kleiner als ein erster Schwellenwert allein die mit dem ersten Verstärkungsfaktor verstärkte des Stroms zu verwenden, wobei der zweite Verstärkungsfaktor kleiner als der erste Verstärkungsfaktor ist.

Die Verstärkung mit dem ersten, größeren Verstärkungsfaktor bietet den Vorteil, dass der als Messverstärker eingesetzte Operationsverstärker wesentlich empfindlicher für kleine Änderungen des Stroms ist, insbesondere auch im Vergleich zu dem zweiten Strommesspfad mit dem niedrigeren zweiten Verstärkungsfaktor. Damit ist die verstärkte des Stroms auch für kleine Werte des zu messenden Stroms aussagekräftig und genau.

Das Kombinationsmittel einer bevorzugten Ausführung ist dafür eingerichtet, für Stromwerte größer als ein erster Schwellenwert und kleiner als ein zweiten Schwellenwert, die gewichtete Kombination der mit dem zweiten Verstärkungsfaktor verstärkten des Stroms mit der mit dem ersten Verstärkungsfaktor verstärkten des Stroms zu verwenden. Dabei ist der zweite Verstärkungsfaktor kleiner als der erste Verstärkungsfaktor, ein erster Gewichtungsfaktor der mit dem ersten Verstärkungsfaktor verstärkten des

Stroms mit zunehmendem Stromwert wird verringert, insbesondere linear verringert, und ein zweiter Gewichtungsfaktor der mit dem zweiten Verstärkungsfaktor verstärkten des Stroms wird mit zunehmendem Stromwert erhöht, insbesondere linear erhöht.

Eine Einrichtung eines Übergangsbereichs, bei dem allmählich mit ansteigendem elektrischen Strom die Gewichtung des stark verstärkten ersten Strommesspfads verringert wird und gegenläufig dazu kompensierend die Gewichtung des schwach verstärkten zweiten Strommesspfads erhöht wird, ist insbesondere deshalb vorteilhaft, da ein hartes Umschalten zwischen Strommesspfaden, und damit zwischen Messbereichen vermieden wird.

Die Schaltungsanordnung nach einer Ausführung weist das Kombinationsmittel dafür ausgelegt auf, für Stromwerte oberhalb eines zweiten Schwellenwerts allein die mit dem zweiten Verstärkungsfaktor verstärkte Messgröße zu verwenden, wobei der zweite Verstärkungsfaktor kleiner als der erste Verstärkungsfaktor ist.

Wenn kein Übergangsbereich zwischen den beiden Bereichen geschaffen werden soll, können die beiden Schwellenwerte insbesondere gleich sein. Wie oben bereits ausgeführt ist dann ein sprunghafter Wechsel zwischen den beiden Bereichen realisiert.

Die Verstärkung mit dem zweiten, kleineren Verstärkungsfaktor bietet den Vorteil, dass der als Messverstärker eingesetzte Operationsverstärker wesentlich weniger schnell bei hohen Strömen in Sättigung geht, insbesondere auch im Vergleich zu dem ersten Strommesspfad mit dem höheren ersten Verstärkungsfaktor. Damit ist die verstärkte Messgröße auch für hohe Werte des elektrischen Stroms aussagekräftig.

Eine vorteilhafte Schaltungsanordnung wird dafür eingesetzt, das kombinierte Signal für einen elektrischen Strom über zumindest eine Leuchtdiode zu ermitteln, wobei der aus dem kombinierten Signal ermittelte Stromistwert in einer Regelschleife für eine Konstantregelung des Stroms als Regelgröße über die Leuchtdiode auf einen vorgegebenen Sollwert (Führungsgröße) verwendet wird.

Die Erfindung ermöglicht eine hochpräzise Regelung des die Lichtabgabe einer LED bestimmenden Stroms durch die Leuchtdiode über einen weiten Dimmbereich. Insbesondere bei einem starken Dimmen auf unter 1 % der Lichtleistung der Leuchtdiode ist eine exakte Regelung der Lichtabgabe der Leuchtdiode so immer noch möglich.

Eine besonders vorteilhafte Verwendung der Schaltungsanordnung nach einem Ausführungsbeispiel, ermittelt einen ersten Strom in einem ersten Kanal eines Zweikanalsystems und einen zweiten Strom in einem zweiten Kanal eines Zweikanalsystems. Der erste Kanal umfasst dabei zumindest eine Leuchtdiode mit einer kaltweißen Farbtemperatur eines abgegebenen Lichts, und der zweite Kanal zumindest eine Leuchtdiode mit einer warmweißen Farbtemperatur eines abgegebenen Lichts.

Werden die Ströme durch die kaltweiße Leuchtdiode und die warmweiße Leuchtdiode jeweils mittels der erfindungsgemäßen Schaltungsanordnung ermittelt, so wird eine präzise Regelung des Stroms durch die Leuchtdioden und damit eine exakte Regelung der Lichtabgabe der einzelnen Leuchtdioden über einen weiten Dimmbereich der Lichtleistung möglich. Eine gewünschte Farbtemperatur des abgegebenen Lichts ist damit auch über einen weiten Dimmbereich möglich. Somit werden dimmbare Leuchten mit einem abstimmbaren Weißlicht (engl. "tunable white"), beispielsweise zwischen 1500 K und 6500 K, mit günstigen und stabilen Eigenschaften realisierbar.

Eine Ausführung der Schaltungsanordnung bildet den ersten Verstärkerschaltkreis und den zweiten Verstärkerschaltkreis als separate diskrete Bauelemente aus.

Für den Einsatz zweier diskreter Operationsverstärker bestehen bereits integrierte handelsübliche Lösungen, die zwei Operationsverstärker in einem gemeinsamen Gehäuse versorgt von einer einzigen Versorgungsspannung $V_{CC}$ aufweisen. Damit ist eine einfache und kostengünstige Realisierung der Erfindung unter Rückgriff auf bestehende Lösungen und unter vorteilhaften Kostenstrukturen und mit lediglich geringen Entwicklungsrisiken möglich.

Eine besonders vorteilhafte Ausführung der Schaltungsanordnung zeichnet sich dadurch aus, dass der erste Verstärkerschaltkreis und der zweite Verstärkerschaltkreis in einem gemeinsamen Bauelementgehäuse angeordnet sind.

Da beide Operationsverstärker in einem gemeinsamen Baugruppengehäuse angeordnet sind, werden die beiden Operationsverstärker im Betrieb ein entsprechendes Temperaturverhalten zeigen. Der Einfluss einer Umgebungstemperatur auf die Strommessung gemäß der Erfindung wird somit in vorteilhafter Weise verringert.

Der zweite Aspekt der Erfindung betrifft ein Verfahren zur Ermittlung des Signals mit den folgenden Schritten : Erfassen einer für den Strom repräsentativen Messgröße, Verstärken der Messgröße in einem ersten Strommesspfad mit einem ersten Verstärkungsfaktor und Verstärken der Messgröße in einem zweiten Strommesspfad mit einem zweiten Verstärkungsfaktor, Erzeugen eines kombinierten Signals und Ausgeben des kombinierten Signals als Basis für die Ermittlung des Stromistwerts. Das Verfahren zeichnet sich dadurch aus, dass Erzeugen eines kombinierten Signals mittels gewichtetem Kombinieren der ersten verstärkten Messgröße mit der zweiten verstärkten Messgröße mit einer Gewichtungsfunktion für die gewichtete Kombination der ersten verstärkten Messgröße mit der zweiten verstärkten Messgröße erfolgt, wobei die Gewichtungsfunktion entsprechend einem Stromwert Gewichtungsfaktoren für den ersten und den zweiten Strommesspfad vorgibt. Der der Stromwert ist dabei ein Sollwert für den zu ermittelnden Strom oder ein Dimmwert ist. Erzeugen eines kombinierten Signals für Stromwerte kleiner als ein erster Schwellenwert verwendet allein die mit dem ersten Verstärkungsfaktor verstärkte Messgröße, wobei der zweite Verstärkungsfaktor kleiner als der erste Verstärkungsfaktor ist.

Die folgenden Beispiele und Ausführungen sind nicht erfindungsgemäß und dienen lediglich der Veranschaulichung der in den Ansprüchen definierten Erfindung.

Ein Verfahren zur Steuerung eines Ausgangsstroms einer Wandlerschaltung zum Betrieb zumindest eines Leuchtmittels nach einem Beispiel zeigt die Wandlerschaltung zumindest einen getakteten Schalter und eine Spule aufweisend. In einem lückenden Betriebsmodus der Wandlerschaltung wird der Ausgangsstrom mittels Steuerung eines Wiedereinschaltzeitpunkts des Schalters nach einer Totzeit gesteuert. Das Verfahren weist zunächst einen Schritt des Ermittelns einer nominalen Totzeit und eines nominalen Spitzenstroms auf. Anschließend wird ein Feld von Zählerständen für einen Spulenstrom über die Spule des Abwärtswandlers erzeugt. Eine neue Totzeit für einen der ermittelten nominalen Totzeit nächstliegenden Nominalwert des Spulenstroms aus dem erzeugten Feld von Zählerständen wird nun bestimmt. Ein Kompensationswert für den Spitzenstrom, um den Laststrom konstant zu halten, wird ermittelt und ein korrigierter Spitzenstrom aus dem nominalen Spitzenstrom unter Verwendung des ermittelten Kompensationswerts erzeugt. Anschließend werden der korrigierte Spitzenstrom und die neue Totzeit zur Steuerung des Ausgangsstroms der Wandlerschaltung ausgegeben.

Das Verfahren ermöglicht eine gezielte Steuerung des Einschaltzeitpunkts des gesteuerten Schalters eines getakteten Wandlers in einem lückenden Betrieb ("Valley switching"), ohne dass eine hochgenaue Strommessung für sehr kleine Stromwerte notwendig ist. Damit kann der schaltungstechnische Aufwand für die Strommessung vorteilhaft verringert werden. Die Lösung nutzt die im Rahmen eines getakteten Wandlers vorhandene Steuerschaltung, üblicherweise ein Mikrokontroller mit Analog-/Digital-Wandlereingängen und Zählern, für eine Bestimmung des Wiedereinschaltzeitpunkts aus einem Minimum des Laststroms aus. Laststromsprünge bei einem Wechsel des Widereinschaltzeitpunkts durch einen Wechsel des ausgewählten Stromminimums über das Feld von Zählerständen lassen sich durch den Korrekturwert für den Spitzenstrom vorteilhaft unterbinden.

Das Verfahren nach einem weiteren Beispiel zeichnet sich dadurch aus, dass der Laststrom basierend auf dem Spitzenstrom und der Totzeit in einem ersten Regelbereich der Wandlerschaltung für hohe Dimmwerte des Laststroms gesteuert wird.

Das Verfahren nach einem weiteren Beispiel regelt den Laststrom basierend auf dem Spitzenstrom und mit konstanter Totzeit in einem zweiten Regelbereich der Wandlerschaltung für geringe Dimmwerte des Laststroms gesteuert wird.

Die Minima des Laststroms sind für hohe Lastströme gut zu erfassen, während bei geringen Lastströmen die Steuerung des Laststroms vorteilhaft mittels der bestimmten Totzeit direkt erfolgt.

Eine Ausführung des Verfahrens zeichnet sich dadurch aus, dass eine neue Totzeit für einen der ermittelten nominalen Totzeit nächstliegenden Minimalwert des Spulenstroms aus dem erzeugten Feld mit einer Hysterese ausgewählt wird,

Eine Auswahl der Totzeit aus dem Feld der Zählerstände unter Berücksichtigung einer Hysterese vermeidet einen schnellen Wechsel der Zählerstände für das Minimum des Spulenstroms und führt zu einem stabilen Steuerungsverhalten des Laststroms, ohne dass sichtbare Schwankungen einer Lichtintensität bemerkbar werden.

Ein vorteilhaftes Beispiel des Verfahrens wählt eine neue Totzeit aus dem in einem Ringspeicher gespeicherten Feld von Zählerständen aus. Die Auslegung der Totzeitbestimmung aus einem Feld von Zählerständen über einen Ringspeicher ermöglicht eine einfache, bekannte Datenstruktur und eine effiziente Speicherauslegung und verringert den Implementierungsaufwand des erfindungsgemäßen Verfahrens.

Eine integrierte Steuervorrichtung ist insbesondere mit einem Mikrokontroller ausgelegt zur Ausführung der Verfahrensschritte nach einem der vorstehend dargestellten Ausführungsbeispiele.

Insbesondere kann die verstärkte Messgröße des ersten und des zweiten Strommesspfads nach dem ersten bzw. dem zweiten Verstärkerschaltkreis in ein digitales Signal gewandelt werden und die anschließende Signalverarbeitung in digitaler Form, vorzugsweise mittels Software, ausgeführt werden. Damit lassen sich vorhandene integrierte Schaltkreise (IC) und Prozessoren nutzen, beispielsweise auch Mikroprozessoren einer Konverterbaugruppe zur Ansteuerung von einem oder mehreren LED-Modulen.

Ein Betriebsgerät für Leuchtmittel kann zumindest eine der vorstehend beschriebenen Schaltungsanordnungen und/oder zumindest eine Steuervorrichtung ausgelegt zur Ausführung der Verfahrensschritte nach einem der vorstehend geschilderten Verfahrensansprüche umfassen.

Das Betriebsgerät ist zum Beispiel für die mehrkanalige und zugleich hochpräzise Ansteuerung von Leuchtmitteln mit unterschiedlichen Farbtemperaturen für die Abgabe von Licht konstanter Farbtemperatur über einen weiten Bereich von Dimmniveaus vorteilhaft.

Ebenso kann ein Verfahren für die Steuerung des Betriebsgeräts für Leuchtmittel die entsprechenden Verfahrensschritte nach einem der vorstehend definierten Verfahren aufweisen.

Im Folgenden werden anhand der Figuren Ausführungsbeispiele der Erfindung dargestellt. Dabei zeigt

Fig. 1      eine Schaltungsanordnung gemäß einem Ausführungsbeispiel,

Fig. 2      ein Schaltungsbeispiel zur Implementierung eines Ausführungsbeispiels,

Fig. 3      eine mögliche Auslegung der Strommessbereiche und einer Gewichtungsfunktion für eine mögliche Implementierung,

Fig. 4      ein einfaches Flussdiagramm einer Ausführung des Verfahrens, und

Fig. 5      ein Ausführungsbeispiel in einer zweikanaligen Beleuchtungsanordnung zur Erzeugung abgleichbaren Weißlichts.

Fig. 6      ein Betriebsgerät für Leuchtmittel mit seinen wesentlichen Funktionsblöcken,

Fig. 7      eine Abwärtswandlerschaltung für den Betrieb von LEDs,

Fig. 8      Beispiele für Signalverläufe der Abwärtswandlerschaltung nach Fig. 7,

Fig. 9      eine Abwärtswandlerschaltung für den Betrieb von LEDs mit Mitteln zur Erfassung der für die Steuerung der Abwärtswandlerschaltung genutzten Signale,

Fig. 10      gemessene typische Signalverläufe der Abwärtswandlerschaltung,

Fig. 11      eine Übersicht von Schaltregionen für die Steuerung der Abwärtswandlerschaltung im lückenden Betrieb mit Schaltansteuerung im Stromminimum,

Fig. 12      eine Übersicht der Funktionsblöcke für ein Ansteuerverfahren für die Abwärtswandlerschaltung,

Fig. 13      eine Signalsequenz für die Ansteuerung der Abwärtswandlerschaltung bei Einstellen eines geänderten Dimmwerts bei Ansteuerung einer LED,

Fig. 14      eine Zeitsequenz zur Bestimmung eines Feldes von Minima für die Bestimmung eines Einschaltzeitpunkts des Schalters des Abwärtswandlers,

Fig. 15      eine Speicherstruktur zur Nutzung bei der Bestimmung eines Minimums für die Bestimmung eines Einschaltzeitpunkts des Schalters des Abwärtswandlers,

Fig. 16      ein Approximationsverfahren zur Verwendung für ein Steuerungsverfahren für die Abwärtswandlerschaltung,

Fig. 17      ein weiteres Approximationsverfahren zur Verwendung für ein Steuerungsverfahren für die Abwärtswandlerschaltung, und

Fig. 18      ein Funktionsblock für die Ermittlung eines neuen Stromspitzenwerts für die Ansteuerung der Abwärtswandlerschaltung bei Einstellen eines geänderten Dimmniveaus.

In den Figuren bezeichnen gleiche Bezugszeichen gleiche oder entsprechende Elemente. Auf die Beschreibung gleicher Bezugszeichen in verschiedenen Figuren wird, wo entbehrlich erachtet, zu Gunsten einer knappen Darstellung verzichtet.

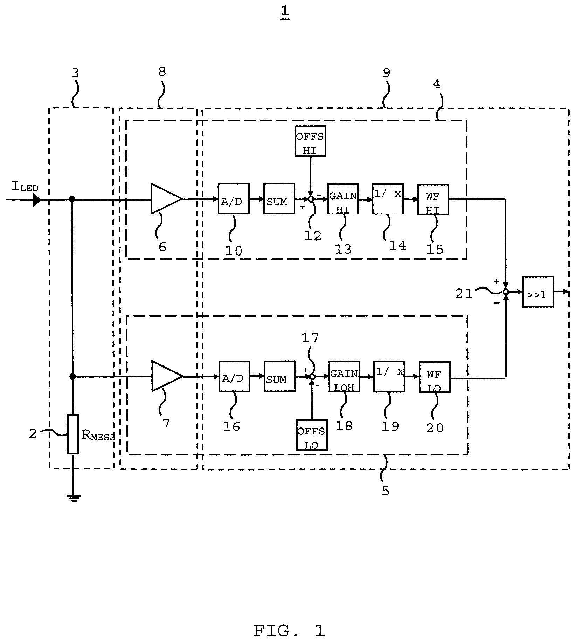

Fig. 1 zeigt eine Schaltungsanordnung 1 gemäß einem Ausführungsbeispiel mit typischen Funktionsblöcken.

Eine Messung eines Stroms mittels eines Messwiderstands $R_{MESS}$ 2 (auch: Shuntwiderstand $R_{SHUNT}$) in einem ersten Funktionsblock 3 ist an sich bekannt. Beispielsweise kann ein Laststrom $I_{LED}$ über eine Leuchtdiode mittels des Spannungsabfalls über den Messwiderstand $R_{MESS}$ 2 erfasst werden. Die Höhe des Spannungsabfalls über den Messwiderstand $R_{MESS}$ 2 entspricht einer Stromstärke des Laststrom $I_{LED}$. Damit wird mittels des Messwiderstands $R_{MESS}$ 2 eine für die Stromstärke des Stroms $I_{LED}$ (Stromistwert) repräsentative Messgröße erzeugt.

Die Messgröße wird anschließend einem ersten Strommesspfad 4 und einem zweiten Strommesspfad 5 zugeführt. Der erste Strommesspfad 4 umfasst einen ersten Operationsverstärker 6. Der zweite Strommesspfad 5 umfasst einen zweiten Operationsverstärker 7. Der erste Operationsverstärker 6 verstärkt die an seinem Eingang anliegende Messgröße mit einem ersten Verstärkungsfaktor. Der zweite Operationsverstärker 7 verstärkt die an seinem Eingang ebenfalls anliegende Messgröße mit einem zweiten Verstärkungsfaktor. Der erste Verstärkungsfaktor und der zweite Verstärkungsfaktor sind dabei unterschiedlich. Insbesondere ist der erste Verstärkungsfaktor größer als der zweite Verstärkungsfaktor.

Der erste Operationsverstärker 6 und der zweite Operationsverstärker 7 sind typisch als nichtinvertierende Operationsverstärker ausgelegt und als separate diskrete Bauelemente ausgeführt. Vorteilhaft ist der zweite Funktionsblock 8 mit dem ersten Operationsverstärker 6 und dem zweiten Operationsverstärker 7 als separate diskrete Halbleiterbauelemente in einem gemeinsamen Bauelementegehäuse mit einer gemeinsamen Stromversorgung für beide Operationsverstärker 6, 7 realisiert. Geeignete Halbleiterbauelemente sind unter den Bezeichnungen LM2904, LM358/LM358A, LM258/LM258A, MCP6002, TLV2333 usw. verfügbar. Die Nutzung eines verfügbaren Zweifach-Operationsverstärkers integriert in einem gemeinsamen Gehäuse mit einer Spanungsversorgung $V_{CC}$ ist vorteilhaft, da zum einen die Kosten lediglich auf die Anpassung der Operationsverstärkerschaltung an den vorliegenden Anwendungsfall anfallen. Weiter ist von einer entsprechenden Temperaturabhängigkeit des ersten Operationsverstärkers 6 und des zweiten Operationsverstärkers 7 auszugehen.

Die erste verstärkte Messgröße und die zweite verstärkte Messgröße werden anschließend einem dritten Funktionsblock 9 zugeführt. Der dritte Funktionsblock 9 ist vorteilhaft in Form von Softwaremodulen implementiert. Alternativ ist eine vollständige oder teilweise Realisierung als Hardware möglich.

Der dritte Funktionsblock 9 umfasst zum einen eine getrennte Signalverarbeitung jeweils des ersten Strommesspfads 4 und des zweiten Strommesspfads 5. Weiter werden im dritten Funktionsblock 9 nach Fig. 1 die erste verstärkte Messgröße und die zweite verstärkte Messgröße gewichtet miteinander kombiniert und als kombiniertes Signal für die zu messende Stromstärke des Laststroms $I_{LED}$ am Ausgang ausgegeben.

Hierzu wird im dritten Funktionsblock 9 in dem ersten Strommesspfad 4 die mit dem ersten Verstärkungsfaktor verstärkte Messgröße abgetastet und einem ersten A/D-Wandler 10 zugeführt und in ein digitales Signal, beispielsweise mit einer Auflösung von 12 Bit gewandelt. Das digitale Signal im ersten Strommesspfad 4 kann mittels Überabtastung, beispielsweise mit einem Faktor von $2^6$ zur Verbesserung der Auflösung, zur Rauschreduktion und zur Vermeidung von Phasenverzerrungen abgetastet werden. In dem ersten Strommesspfad kann das digitale Signal über Addition eines ersten Offsets in einem ersten Addierer 12 und Multiplikation mit einem ersten Signalgewinn in einem ersten Multiplizierer 13 weiter angepasst werden.

Entsprechend wird im dritten Funktionsblock 9 in dem zweiten Strommesspfad 5 die mit dem zweiten Verstärkungsfaktor verstärkte Messgröße abgetastet und einem zweiten A/D-Wandler 16 zugeführt und in ein digitales zweites Signal, beispielsweise mit einer Auflösung von 12 Bit gewandelt. Das digitale zweite Signal in dem zweiten Strommesspfad 5 kann mittels Überabtastung abgetastet werden. In dem zweiten Strommesspfad kann das digitale zweite Signal über Addition eines zweiten Offsets in einem zweiten Addierer 17 und Multiplikation mit einem zweiten Signalgewinn in einem zweiten Multiplizierer 18 zusätzlich angepasst werden.

Anschließend werden im dritten Funktionsblock 9 nach den vorstehend dargestellten Signalvorverarbeitungsschritten die erste verstärkte Messgröße und die zweite verstärkte Messgröße bzw. die daraus wie oben beschrieben gewonnen Signale gewichtet miteinander kombiniert. Zur einfacheren Darstellung wird jedoch weiterhin die Verarbeitung der ersten bzw. zweiten verstärkten Messgröße zur Erläuterung verwendet, da insbesondere die Zwischenverarbeitung auch in anderer Weise ausgeführt oder wenigstens größtenteils nicht durchgeführt sein kann. Die Kombination ist in Fig. 1 mittels Teilen der ersten verstärkten Messgröße im ersten Strommesspfad 4 durch einen beliebigen Wert x in einem ersten Teiler 14 und anschließender Multiplikation mit einem ersten Gewichtungsfaktor WFH in einem ersten Multiplikator 15 gezeigt. Entsprechend wird in dem zweiten Strommesspfad 5 die zweite verstärkte Messgröße in einem zweiten Teiler 19 durch einen beliebigen Wert x dividiert und anschließend mit einem zweiten Gewichtungsfaktor WFL in einem zweiten Multiplikator 20 multipliziert. Der Wert x des ersten Teilers 14 und des zweiten Teilers 19 können den gleichen oder einen unterschiedlichen Betrag haben.

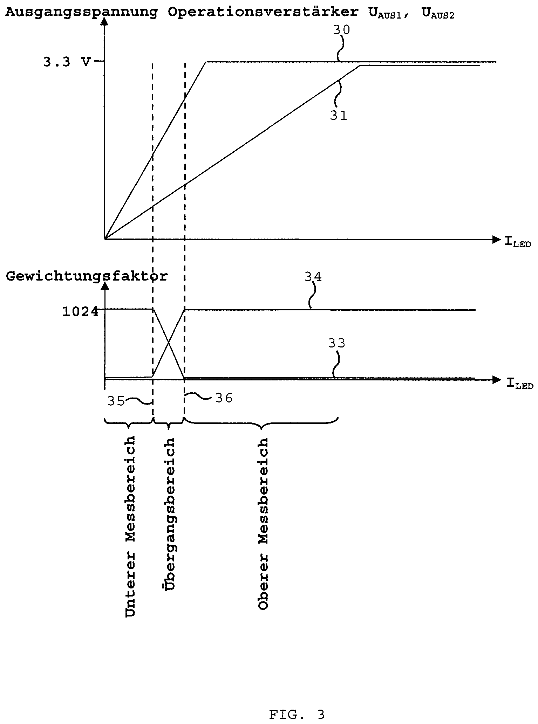

Die erste gewichtete Messgröße und die zweite gewichtete Messgröße werden einem Addierer 21 zugeführt und miteinander addiert, um das kombinierte Signal zu erzeugen. Das kombinierte Signal wird anschließend als Basis für die Ermittlung des Laststroms $I_{LED}$ ausgegeben. Die jeweilige Verstärkung, Gewichtung und Kombination der ersten und zweiten verstärkten Messgröße werden mit Bezug zu Fig. 3 nachfolgend näher erläutert.

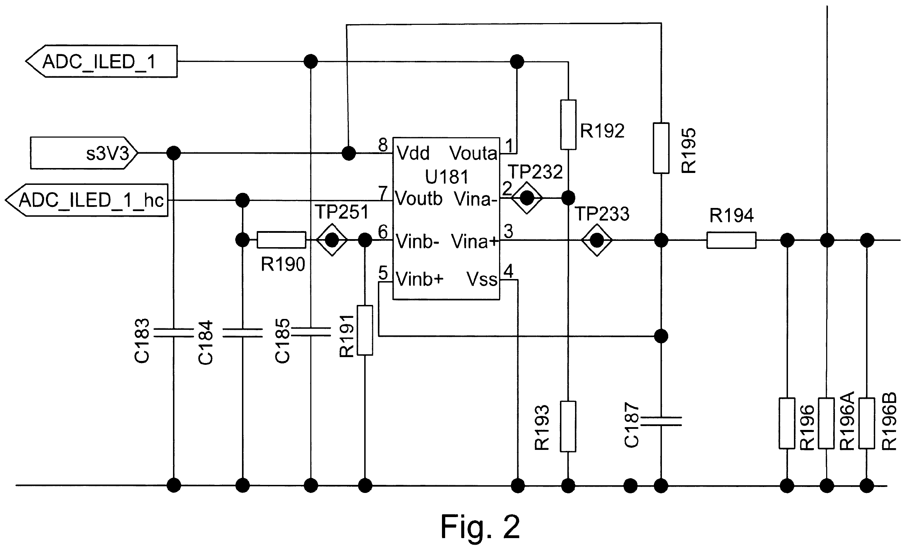

Fig. 2 stellt ein Schaltungsbeispiel zu Teilen einer möglichen Implementierung der Erfindung dar. Dabei sind in Fig. 2 in analoger Technologie ausgeführte Schaltungsbeispiele für den ersten und den zweiten Funktionsblock 3, 8 nach Fig. 1 gezeigt.

Der erste Operationsverstärker 6 und der der zweite Operationsverstärker 7 sind als ein diskreter integrierter Schaltkreis in einem elektronischen Bauelement realisiert. Dem ersten Operationsverstärker 6 und dem zweiten Operationsverstärker 7 wird die Messgröße zugeführt. Die Messgröße wird mittels des Messwiderstands $R_{MESS}$ 2 erzeugt, der in Fig. 2 durch die diskreten Widerstände R196, R196A und R196B realisiert ist. Die Messgröße wird anschließend mittels eines RC-Glieds als Tiefpassfilter geglättet, das mittels des Widerstands R194 und des Kondensators C187 aufgebaut ist. Die gefilterte Messgröße wird anschließend jeweils an den nichtinvertierenden Eingang des ersten Operationsverstärkers 6 und des zweiten Operationsverstärkers 7 gelegt.

Der erste Verstärkungsfaktor des ersten Operationsverstärkers und der zweite Verstärkungsfaktor des zweiten Operationsverstärkers werden unterschiedlich eingestellt. Dies erfolgt über die Widerstände R192 und R193, sowie R190 und R191

Mittels eines Spannungsteilers aus dem Widerstand R195 und den Widerständen R194, R196, R196A, R196B werden die nichtinvertierenden Eingänge des ersten Operationsverstärkers 6 und des zweiten Operationsverstärkers 7 auf ein geeignetes Potential gelegt, um eine Abweichung einer eingangsseitigen Offsetspannung des ersten und des zweiten Operationsverstärkers 6, 7 zu kompensieren.

Ein Rauschanteil der ersten verstärkten Messgröße am Ausgang des ersten Operationsverstärkers 6 wird durch den Kondensator C185 verringert bzw. unterdrückt, der zwischen Ausgang des ersten Operationsverstärkers und Erde geschaltet ist. Entsprechend wird ein Rauschanteil der zweiten verstärkten Messgröße am Ausgang des zweiten Operationsverstärkers 7 durch den Kondensator C184 verringert bzw. unterdrückt, indem der Kondensator 184 zwischen Ausgang des zweiten Operationsverstärkers und Erde angeordnet ist.

Die schaltungstechnische Auslegung nach Fig. 2 stellt lediglich eine mögliche von einer Vielzahl denkbarer Realisierungsmöglichkeiten des ersten und des zweiten Funktionsblocks 3, 8 der erfindungsgemäßen Schaltungsanordnung 1 dar.

Fig. 3 gibt eine mögliche Auslegung der Strommessbereiche und eine Ausbildung der Gewichtungsfunktion für eine mögliche Implementierung der erfindungsgemäßen Schaltungsanordnung 1 wieder.

In der oberen Teilfigur 3 ist auf der Abszisse ein Laststrom $I_{LED}$ (Stromistwert) aufgetragen. Die untere Teilfigur 3 zeigt auf der Abszisse ebenfalls den Laststrom $I_{LED}$ entsprechend zugeordnet zu der oberen Teilfigur 3.

Die obere Teilfigur 3 trägt auf der Ordinate eine Ausgangsspannung des ersten bzw. des zweiten Operationsverstärkers 6, 7 auf. Die obere Teilfigur 3 zeigt in einer ersten Kurve den Verlauf 30 der Ausgangsspannung $U_{AUS1}$ des ersten Operationsverstärkers 6 in Abhängigkeit von dem Laststrom $I_{LED}$ als dem zu messenden bzw. auf Basis des erfindungsgemäß erzeugten Signal ermittelten Stroms. Die Ausgangsspannung des ersten Operationsverstärkers 6 steigt ausgehend von einem Stromwert $I_{LED} = 0$ linear mit einem konstanten ersten Verstärkungsfaktor an, bis eine Sättigungsspannung, im gezeichneten Fall bei $U_{AUS1} = 3.3$ V erreicht wird. Die zweite Kurve 31 in der oberen Teilfigur 3 gibt den Verlauf der Ausgangsspannung $U_{AUS2}$ des zweiten Operationsverstärkers 7 in Abhängigkeit von dem Laststrom $I_{LED}$ als dem zu messenden Strom wieder. Die Ausgangsspannung $U_{AUS2}$ des zweiten Operationsverstärkers 7 steigt ausgehend von einem zu messenden Strom $I_{LED} = 0$ linear mit einem konstanten zweiten Verstärkungsfaktor an, bis auch hier die Sättigungsspannung bei $U_{AUS2} = 3.3$ V erreicht wird. Dies trifft für die flacher verlaufende zweite Kurve 31 erst für einen deutlich höheren Wert des Laststroms $I_{LED}$ zu als für die erste Kurve 30.

Aus einem Vergleich der ersten Kurve 30 mit der zweiten Kurve 31 in der oberen Teilfigur 3 ist ersichtlich, dass der erste Verstärkungsfaktor des ersten Operationsverstärkers 6 größer als der zweite Verstärkungsfaktor des zweiten Operationsverstärkers 7 ist. Während das Ausgangssignal des ersten Operationsverstärkers 6 wesentlich empfindlicher auf geringe Änderungen des zu messenden Stroms und damit der Messgröße reagiert, kann das Ausgangssignal des zweiten Operationsverstärkers 7 deutlich größeren Werten des zu messenden Stroms bzw. der Messgröße folgen, ohne in Sättigung zu gehen.

Die untere Teilfigur 3 gibt nun den Verlauf einer Gewichtungsfunktion für die Kombination der ersten verstärkten Messgröße und der zweiten verstärkten Messgröße wieder. Die Gewichtungsfunktion der unteren Teilfigur 3 umfasst eine erste Gewichtungsfunktion zur Gewichtung der ersten verstärkten Messgröße und eine zweite Gewichtungsfunktion zur Gewichtung der zweiten verstärkten Messgröße. Die Gewichtungsfunktion kann in Anlehnung an das in Fig. 1 dargestellte Beispiel mit einem ersten Gewichtungsfaktor WFH und einem zweiten Gewichtungsfaktor WFL Werte zwischen 0 und 1024 annehmen.

Die erste Gewichtungsfunktion 33 verläuft in einem ersten Bereich waagrecht bei einem konstanten Gewichtungsfaktor in Höhe von 1024. Die zweite Gewichtungsfunktion 35 verläuft in diesem ersten Bereich konstant mit einem Wert von 0. Der erste Bereich bestimmt damit einen unteren Messbereich zur Messung des Laststroms $I_{LED}$ in dem ausschließlich die erste verstärkte Messgröße herangezogen wird. Damit ist für kleine Werte des zu ermittelnden Stroms lediglich der erste Strommesspfad 4 mit dem höheren ersten Verstärkungsfaktor relevant, der eine höhere Messempfindlichkeit für kleine Stromänderungen aufweist.

In einem zweiten Bereich, der sich unmittelbar an den ersten Bereich für Ströme $I_{LED}$ größer als ein erster Schwellenwert 35 anschließt, sinkt die erste Gewichtungsfunktion 33 linear für zunehmende Ströme. Zugleich steigt die zweite Gewichtungsfunktion 34 in diesem zweiten Bereich konstant ausgehend von einem Wert von 0 bis auf 1024. Der zweite Bereich in der unteren Teilfigur 3 bestimmt damit einen Übergangsbereich (Übergangsmessessbereich) zur Messung des Laststroms $I_{LED}$ in dem die erste verstärkte Messgröße mit abnehmendem Anteil, die zweite verstärkte Messgröße hingegen mit einem zunehmenden Anteil zur Ermittlung des kombinierten Signals herangezogen wird. Dieser Übergangsbereich endet für einen Wert des Laststroms $I_{LED}$, bei dem die erste Gewichtungsfunktion 33 auf einen ersten Gewichtungsfaktor von 0 abgefallen ist und die zweite Gewichtungsfunktion 34 auf eine Gewichtungsfaktor von 1024 im dargestellten Fall angestiegen ist.

Für Ströme oberhalb eines zweiten Schwellenwerts 36 verläuft in einem dritten Bereich (Oberer Messbereich) die erste Gewichtungsfunktion waagrecht bei einem konstanten Gewichtungsfaktor in Höhe von 0. Die zweite Gewichtungsfunktion verläuft in diesem ersten Bereich waagrecht mit einem Wert von 1024. Der dritte Bereich bestimmt damit einen oberen Messbereich zur Messung des Laststroms $I_{LED}$ in dem ausschließlich die zweite verstärkte Messgröße herangezogen wird. Damit ist für große Werte des zu messenden Stroms lediglich der zweite Strommesspfad 5 mit dem niedrigeren zweiten Verstärkungsfaktor relevant, der für große Stromwerte weniger schnell in Sättigung geht.

Der untere Schwellenwert 35 zwischen dem unteren Messbereich und dem Übergangsbereich, und der obere Schwellenwert 35 zwischen dem Übergangsbereich und dem oberen Messbereich liegen beide in einem Bereich der Messgröße, in dem weder der erste Operationsverstärker 6 noch der zweite Operationsverstärker 7 in Sättigung gehen.

Anhand von Fig. 3 wird eine abschnittsweise lineare Gewichtungsfunktion für die gewichtete Kombination der ersten verstärkten Messgröße und der zweiten verstärkten Messgröße herangezogen, die drei Bereiche aufweist, die durch einen ersten Schwellenwert 35 und einen zweiten Schwellenwert 36 für die Größe eines Stroms, hier des Laststroms $I_{LED}$, getrennt werden. Die Erfindung ist ebenso für einen ersten Schwellenwert 35 und einen zweiten Schwellenwert 36, die als Dimmwerte für ein abzugebendes Licht beschrieben werden, anwendbar.

Ebenso kann eine Umsetzung der Erfindung auf einen Übergangsbereich zwischen einem oberen Messbereich und einem oberen Messbereich verzichten. In diesem Fall sind der erste Schwellenwert und der zweite Schwellenwert gleich groß.

Alternativ können auch abschnittsweise definierte Gewichtungsfunktionen mit mehr als drei Abschnitten im Rahmen der Erfindung herangezogen werden.

Weiter ist die Gewichtungsfunktion nicht auf abschnittsweise lineare Gewichtungsfunktionen, wie in Fig. 3 zur einfachen Darstellung herangezogen, beschränkt.

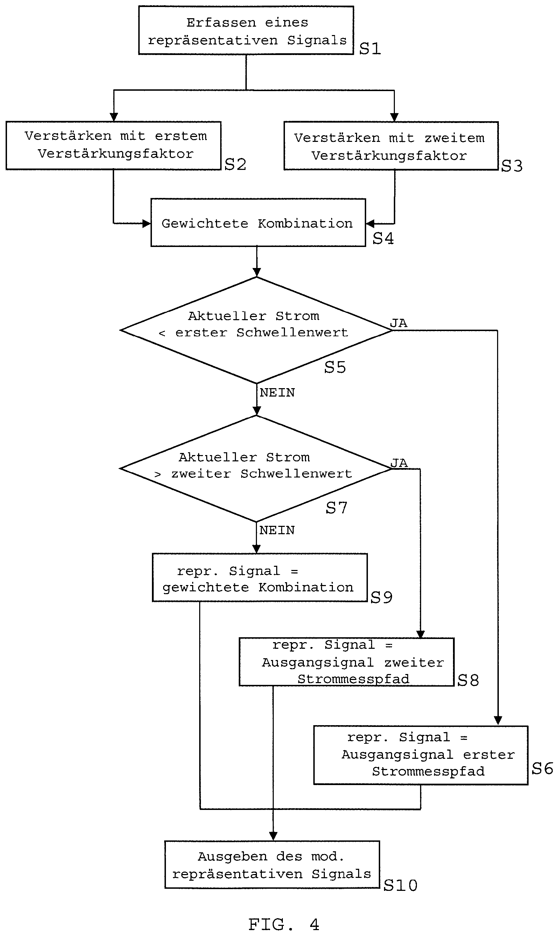

In Fig. 4 wird ein einfaches Flussdiagramm einer Ausführung des erfindungsgemäßen Verfahrens gezeigt.

In einem Schritt S1 wird eine für einen elektrischen Strom repräsentative Messgröße erfasst.

In einem Schritt S2 wird diese erfasste Messgröße einem ersten Strommesspfad 4 zugeführt und in dem ersten Strommesspfad 4 in einem ersten Verstärkerschaltkreis, beispielsweise einem ersten diskreten Operationsverstärker 6 mit einem ersten Verstärkungsfaktor verstärkt.

In einem Schritt S3 wird die erfasste Messgröße einem zweiten Strommesspfad 5 zugeführt und in dem zweiten Strommesspfad 5 in einem zweiten Verstärkerschaltkreis, beispielsweise einem zweiten, diskreten Operationsverstärker 7 mit einem zweiten Verstärkungsfaktor verstärkt.

Der erste Verstärkungsfaktor ist dabei größer als der zweite Verstärkungsfaktor.

Die Schritte S2 und S3 können gleichzeitig und parallel ausgeführt werden. Ebenso ist eine sequentielle Ausführung der Schritte S2 und S3 möglich.

Die in Schritt S2 mit dem ersten Verstärkungsfaktor verstärkte Messgröße und die mit einem zweiten Verstärkungsfaktor verstärkte Messgröße werden anschließend in einem Schritt S4 mittels einer Gewichtungsfunktion gewichtet miteinander kombiniert, um ein kombiniertes Signal zu erzeugen.

In Figur 4 nicht dargestellt ist ein Schritt des Einlesens eines Sollwerts für den zu ermittelnden elektrischen Strom. Alternativ oder zusätzlich kann ein Dimmwert, beispielsweise über eine Schnittstelle, beispielsweise eine DALI-Schnittstelle 37 zu einem Steuergerät für ein Beleuchtungssystem eingelesen werden.

In einem Schritt S5 wird der Sollwert des zu messenden Stroms mit einem ersten Schwellenwert 35 für den Strom verglichen. Ist der Sollwert des zu messenden Stroms kleiner als der erste Schwellenwert 35, so wird das Verfahren mit dem Schritt S6 fortgesetzt.

In Schritt S6 wird das Ausgangssignal des ersten Signalpfads 4, also die mit dem größeren ersten Verstärkungsfaktor verstärkte Messgröße ausgewählt und als kombiniertes Signal für den zu messenden Stromwert gesetzt.

Wird in Schritt S5 hingegen bei dem Vergleich des Sollwerts des zu messenden Stroms mit dem ersten Schwellenwert 35 für den Strom bestimmt, dass der Sollwert des zu messenden Stroms größer oder gleich dem ersten Schwellenwert 35 ist, so wird das Verfahren mit Schritt S7 fortgesetzt.

In Schritt S7 wird der Sollwert des zu messenden Stroms mit einem zweiten Schwellenwert 36 für den Strom verglichen. Ist der Sollwert des zu messenden Stroms größer als der zweite Schwellenwert 36, so wird das Verfahren mit dem Schritt S8 fortgesetzt.

In Schritt S8 wird das Ausgangssignal des zweiten Signalpfads, also die mit dem kleineren zweiten Verstärkungsfaktor verstärkte Messgröße ausgewählt und als kombiniertes Signal für den zu messenden Stromwert gesetzt.

Wird in Schritt S7 hingegen bei dem Vergleich des Sollwerts des zu messenden Stroms mit einem zweiten Schwellenwert 36 für den Strom bestimmt, dass der Sollwert des zu messenden Stroms kleiner oder gleich dem zweiten Schwellenwert 35 ist, so wird das Verfahren mit Schritt S9 fortgesetzt.

Im Schritt S9 wird anschließend die gewichtete Kombination der mit dem ersten Verstärkungsfaktor verstärkten Messgröße und der mit dem zweiten Verstärkungsfaktor verstärkten Messgröße als das gewichtete repräsentative Signal ausgewählt und als kombiniertes Signal für den zu messenden Stromwert gesetzt.

In einem auf die Schritte S6, S8 oder S9 folgenden Schritt S10 wird anschließend das kombinierte Signal für die weitere Verarbeitung ausgegeben. Das modifizierte gewichtete repräsentative Signal kann beispielsweise als Regelgröße in einem Regelkreis zur Regelung eines elektrischen Stroms auf einen Sollwert für den elektrischen Strom genutzt werden. Insbesondere kann der elektrische Strom $I_{LED}$ über eine Leuchtdiode und damit die Stärke des von der Leuchtdiode abgegebenen Lichts geregelt werden. Es muss also aus dem kombinierten Signal nicht erst der tatsächliche Stromwert ermittelt werden. Allerdings ist eine Ausgabe des tatsächlichen Stromwerts für eine weitere Verarbeitung eventuell vorteilhaft. Diese Ermittlung kann z.B. mit Hilfe einer Nachschlagetabelle erfolgen, die jedem Wert des kombinierten Signals einen Stromwert zuordnet.

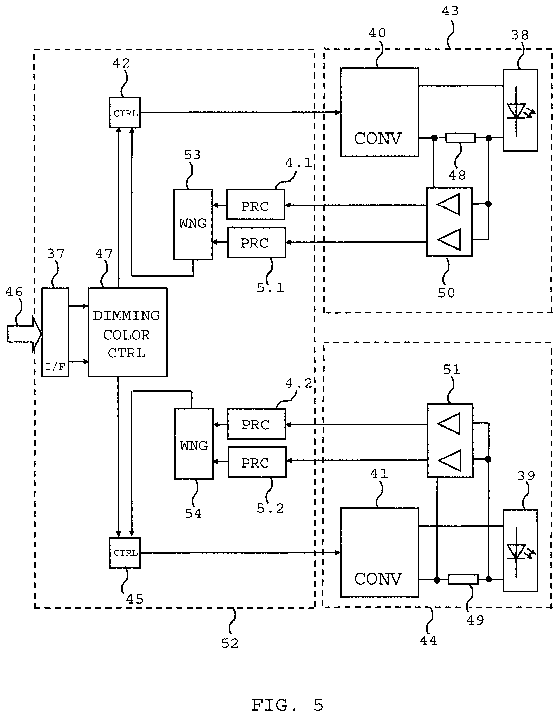

In Fig. 5 wird ein Ausführungsbeispiel der erfindungsgemäßen Schaltungsanordnung 1 in einer zweikanaligen Beleuchtungsanordnung zur Erzeugung abgleichbaren Weißlichts eingesetzt.

Die zweikanalige Beleuchtungsanordnung umfasst zumindest eine erste Leuchtdiode 38 in einem ersten Kanal 43, eingerichtet beispielsweise zur Abgabe von weißem Licht mit einer kaltweißen Farbtemperatur. Die Farbtemperatur des abgegebenen kaltweißen Lichts kann beispielsweise in einem Bereich von über 3300 K, insbesondere auch über 5300 K liegen.

Die zweikanalige Beleuchtungsanordnung umfasst weiter zumindest eine zweite Leuchtdiode 39 in einem zweiten Kanal 44, eingerichtet beispielsweise zur Abgabe von weißem Licht mit einer warmweißen Farbtemperatur. Die Farbtemperatur des abgegebenen warmweißen Lichts kann beispielsweise in einem Bereich von unter 3300 K liegen.

Mittels einer Steuerung des Verhältnisses der Lichtstärke des abgegebenen Lichts der ersten Leuchtdiode 38 und der zweiten Leuchtdiode 39 kann eine Farbtemperatur des durch die gesamte Leuchtenanordnung umfassend die erste Leuchtdiode 38 und die zweite Leuchtdiode 39 abgegebenen Lichts eingestellt werden.

Weiter ist über die Einstellung der Stärke des abgegeben Lichts der ersten Leuchtdiode 38 und der zweiten Leuchtdiode 39 eine gesamte Lichtstärke der Leuchtenanordnung nach Fig. 5 einstellbar.

Die Einstellung der Stärke des abgegeben Lichts der ersten Leuchtdiode 38 erfolgt über den durch einen ersten Konverterschaltkreis 40 an die erste Leuchtdiode 38 abgegebenen ersten elektrischen Strom.

Die Einstellung einer Stärke des abgegebenen Lichts der zweiten Leuchtdiode 39 erfolgt über den durch einen zweiten Konverterschaltkreis 41 an die zweite Leuchtdiode abgegebenen zweiten elektrischen Strom.

Der erste Strom wird von dem ersten Konverterschaltkreis 40 angesteuert von einem ersten Stromsteuerkreis 42 erzeugt. Dazu werden dem ersten Stromsteuerkreis 42 ein Sollwert für den ersten Strom und ein erfindungsgemäß ermittelter repräsentativer Wert für den tatsächlichen ersten Strom, also ein erfindungsgemäß erzeugtes kombiniertes Signal zugeführt. Der erste Stromsteuerkreis 42 erzeugt auf der Grundlage des Sollwerts für den ersten Strom und des erfindungsgemäß ermittelten kombinierten Signals für den ersten Strom ein Ansteuersignal für den ersten Konverterschaltkreis 40, um den Laststrom über die erste Leuchtdiode 39 als Führungsgröße für die erste Leuchtdiode 39 entsprechend dem Sollwert für den ersten Strom zu regeln.

Entsprechend dem ersten Kanal 43 wird für den zweiten Kanal 44 ein zweiter Strom von dem zweiten Konverterschaltkreis 41 angesteuert von einem zweiten Stromsteuerkreis 45 erzeugt. Dazu werden dem zweiten Stromsteuerkreis 45 ein Sollwert für den zweiten Strom und ein erfindungsgemäß ermittelter repräsentativer Wert für den tatsächlichen zweiten Strom, also ebenfalls ein entsprechendes kombiniertes Signal, zugeführt. Der zweite Stromsteuerkreis 45 erzeugt auf der Grundlage des Sollwerts für den zweiten Strom und des erfindungsgemäß ermittelten kombinierten Signals für den zweiten Strom ein Ansteuersignal für den zweiten Konverterschaltkreis 41, um den Laststrom als Führungsgröße für die zweite Leuchtdiode 39 entsprechend dem Sollwert für den zweiten Strom zu regeln.

Die Beleuchtungsanordnung nach Fig. 5 erhält über eine Schnittstelle 37 ein externes Signal 46 mit einer Information als Vorgabe für eine Farbtemperatur des abzugebenden Lichts und eine Lichtstärke des abzugebenden Lichts, beispielsweise über eine Nutzereingabe, einen Lichtsteuerschalter oder ein Bussystem zur Lichtsteuerung nach einem Standard wie zum Beispiel DALI™.

Die vorgegebene Lichtstärke kann beispielsweise eine Form eines Dimmwerts in einem Bereich von unter 1 % bis 100 % umfassen.

Die vorgegebene Lichtfarbe kann beispielsweise eine Farbtemperaturvorgabe für das abzustrahlende Licht in einem Bereich von 1500 bis 6500 K umfassen.

Die Schnittstelle 37 setzt das empfangene externe Signal 46 in eine erste Steuerinformation für den ersten Kanal 43 und eine zweite Steuerinformation für den zweiten Kanal 44 um. Die erste Steuerinformation und die zweite Steuerinformation werden anschließend von der Schnittstelle an eine Dimm- und Farbtemperatursteuerung 47 übermittelt. Die Dimm- und Farbtemperatursteuerung 47 erzeugt aus der ersten Steuerinformation den Sollwert für den ersten Strom und aus der zweiten Steuerinformation den Sollwert für den zweiten Strom. Der Sollwert für den ersten Strom wird an den ersten Stromsteuerkreis 42 übermittelt. Der Sollwert für den zweiten Strom wird an den zweiten Stromsteuerkreis 45 übermittelt.

Aus Fig. 5 ist weiter zu entnehmen, dass die Elemente erster Konverterschaltkreis 40, zweiter Konverterschaltkreis 41, erster Strommesswiderstand 48, zweiter Strommesswiderstand 49, erste Leuchtdiode 38, zweite Leuchtdiode 39 sowie erster Verstärkerschaltkreis 50 und zweiter Verstärkerschaltkreis 51 vorteilhaft in Form von Hardwarebaugruppen für den ersten Kanal 43 und für den zweiten Kanal 44 zu realisieren sind.

Die Funktion der Baugruppen Schnittstelle 37, Dimm- und Farbtemperatursteuerung 47, sowie Abschnitte des ersten Strommesspfads 4, 4.1, 4.2 und des zweiten Strommesspfad 5, 5.1, 5.2 sind in Hardware, alternativ teilweise oder auch vollständig als Software 52 zu implementieren. Dies kann auch die gewichtete Kombination 53, 54 der Ausgänge des ersten Strommesspfads 4, 4.1, 4.2 und des zweiten Strommesspfads 5, 5.1, 5.2 jeweils für den ersten Kanal 43 und den zweiten Kanal 44 umfassen. Die Software 52 kann auf einem oder mehreren integrierten Schalkreisen, insbesondere auch auf einem oder mehreren Mikroprozessoren laufen.

Die Nutzung der erfindungsgemäßen Schaltungsanordnung 1 zur Strommessung im Rahmen einer zweikanaligen Beleuchtungsanordnung zur Abgabe dimmbaren und in seiner Farbtemperatur abstimmbaren Weißlichts ist eine besonders vorteilhafte Anwendung. Ebenso vorteilhaft kann die Erfindung in jeder dimmbaren und in der Farbtemperatur einstellbaren Leuchte eingesetzt werden. Grundsätzlich ist die Erfindung im Rahmen weiterer Anordnungen, die eine genaue Strommessung über einen weiten Dynamikbereich erfordern im Rahmen des Umfangs der beiliegenden Patentansprüche nutzbar.

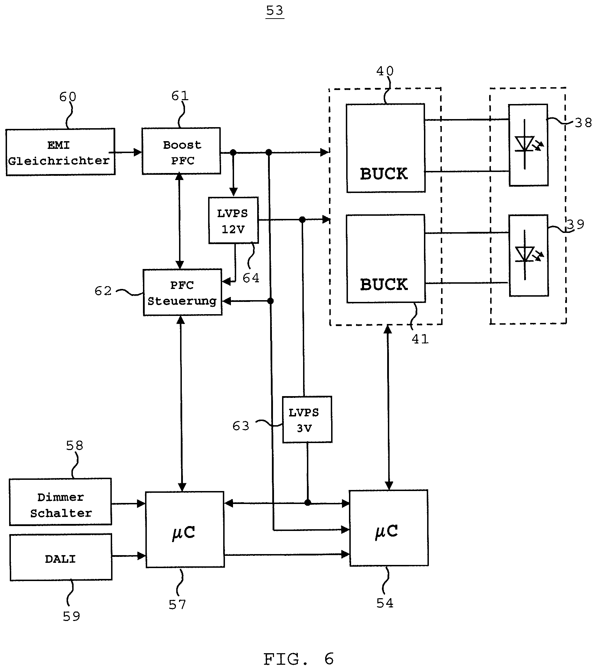

Eine Anwendung der Erfindung erfolgt im Rahmen eines Betriebsgeräts für Leuchtmittel, das im Folgenden anhand der Figuren 6 bis 21 erläutert wird.

Fig. 6 zeigt ein Betriebsgerät 53, insbesondere für Leuchtmittel, mit seinen wesentlichen Funktionsblöcken. Die Leuchtmittel können zum Beispiel eine oder mehrere Leuchtdioden (LED) 38, 39 in Reihen- und/oder Serienschaltung umfassen. Dargestellt in Fig. 6 sind zwei LED 38, 39, die von dem ersten Konverterschaltkreis 40 bzw. dem zweiten Konverterschaltkreis 41 mit einem Strom (Laststrom) versorgt werden.

In Fig. 6 ist die Erfassung des Laststroms mittels eines ersten Strommesswiderstands 48 und zweiten Strommesswiderstands 49 zeichnerisch nicht dargestellt. Die Regelung der Lastströme durch die erste Leuchtdiode 38 und die zweite Leuchtdiode 39 erfolgt in einem Steuerschaltkreis 54, der vorteilhaft als Mikrokontroller ausgeführt sein kann. Der Steuerschaltkreis 54 wird selbst von einem zweiten Steuerschaltkreis 57 angesteuert und erhält über diesen insbesondere Steuersignale, die eine Ansteuerung der ersten Leuchtdiode 38 und der zweiten Leuchtdiode 39 entsprechend externer Vorgaben, zum Beispiel einer Dimmwertvorgabe oder eines Schaltzustandes, zum Beispiel "Licht an", "Licht aus" oder einer gewünschten Farbtemperatur des abzugebenden Lichts der ersten Leuchtdiode 38 und der zweiten Leuchtdiode 39 umfassen. Der zweite Steuerschaltkreis 57 kann entsprechende externe Vorgaben über einen Dimmer, einen Schalter 58, oder alternativ oder zusätzlich über eine Schnittstelle 59, zum Beispiel über eine DALI™-Schnittstelle einlesen.

Das Betriebsgerät 53 nach Fig. 6 verfügt weiter über eine Schnittstelle zu einer Netzstromversorgung, über die ein Netzeingangssignal, zum Beispiel eine Wechselstromversorgung einer Schaltung mit einem Netzeingangsfilter (EMI-Filter) und Gleichrichter 60 zugeführt wird. Das gleichgerichtete und gefilterte Signal wird dann in einem Leistungsfaktorkorrekturglied 61 weiterverarbeitet. Das Leistungsfaktorkorrekturglied 61 (engl. Power Factor Correction abgekürzt PFC) erhöht den Leistungsfaktor, zum Beispiel in einen gesetzlich vorgeschriebenen Bereich, und kann als Aufwärtswandler ausgeführt werden. Dazu wird ein Schalter des Aufwärtswandlers von einer Steuerschaltung, zum Beispiel einem PFC-Steuerschaltkreis 62, getaktet angesteuert.

Das Leistungsfaktorkorrekturglied 61 stellt dem ersten Konverterschaltkreis 40 und dem zweiten Konverterschaltkreis 41 eine Gleichspannung bereit. Die Gleichspannung am Ausgang des Leistungsfaktorkorrekturglieds 61 wird ebenfalls einem Eingang einer Niedervoltspannungsversorgung 12V 64 zugeführt.

Die in Fig. 6 gezeigte Darstellung des Betriebsgeräts 53 gibt lediglich eine von vielen möglichen Strukturen und Aufteilungen in Funktionsblöcke wieder. Die erfindungsgemäße Ermittlung eines Stromistwerts ist dabei in den Funktionsblöcken des ersten Konverterschaltkreises 40, des zweiten Konverterschaltkreises 41, der ersten Leuchtdiode 38, der zweiten Leuchtdiode 39 und des Steuerschaltkreises 54 angeordnet.

Für die Spannungsversorgung des PFC-Steuerschaltkreises 62, des Steuerschaltkreises 54 und des weiteren Steuerschaltkreises 57 ist in dem Ausführungsbeispiel nach Fig. 6 eine Niedervoltspannungsversorgung 3V 63 und die Niedervoltspannungsversorgung 12V 64 gezeigt.

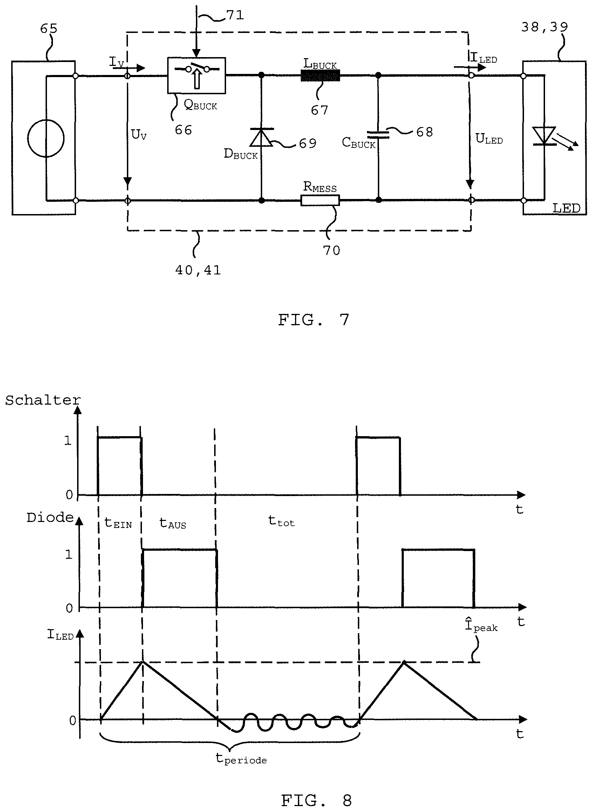

In Fig. 7 ist eine Abwärtswandlerschaltung für den Betrieb von Leuchtdioden 38, 39 gezeigt, wie sie beispielsweise in dem ersten und dem zweiten Konverterschaltkreis 40, 41 eingesetzt werden kann. Es ist festzuhalten, dass ebenso andere Schaltungsstrukturen für geschaltete Schaltnetzteile, beispielsweise Hochsetzsteller, Tiefsetzsteller, ...eingesetzt werden können. Der Abwärtswandlerschaltung wird eine Gleichspannung $U_V$ von einer Gleichspannungsquelle 65 zugeführt. Die Gleichspannungsquelle 65 modelliert in Fig. 7 damit den Ausgang des Leistungsfaktorkorrekturglieds 61 nach Fig. 6 nach.

Der Abwärtswandler stellt eine Ausgangsspannung und einen Ausgangsstrom für den Betrieb der Leuchtdiode 38, 39 bereit. Die Ausgangsspannung entspricht einer Lastspannung $U_{LED}$ über die Leuchtdiode 38, 39. Der Ausgangsstrom entspricht einem Laststrom $I_{LED}$ für das LED-Modul 3. Die Erfindung kann mit anderen getakteten Konvertern ebenso realisiert werden.

Ein Schalter 66, meist als ein <u>Transistor</u> ausgeführt, wird angesteuert von dem Steuerschaltkreis 54 mit einem Schaltersteuersignal 71 periodisch regelmäßig ein- und ausgeschaltet. Üblich sind einige hundert bis mehrere Millionen Schaltzyklen je Sekunde. Dadurch wird elektrische Energie von der eingangsseitig angeschlossenen Spannungsquelle 65 zu der am Ausgang der Abwärtswandlerschaltung angeschlossenen Leuchtdiode 38, 39 als Last übertragen. Die beiden reaktiven Schaltelemente Spule (Induktivität) $L_{BUCK}$ 67 und Ausgangskapazität (Ausgangskondensator) $C_{BUCK}$ 68 ermöglichen als Energiespeicher die Versorgung der Leuchtdiode 38, 39 mit elektrischer Energie in den Zeitphasen, in denen der Schalter 66 geöffnet ist. Die Induktivität der Spule $L_{BUCK}$ 67 trennt eine hohe Eingangsspannung $U_V$ von der Leuchtdiode 38, 39. Der Ausgangsstrom $I_{LED}$ kann durch eine geeignete Steuerung einer Einschaltzeit $t_{EIN}$ und einer Ausschaltzeit $t_{AUS}$ des Schalters 66 eingestellt werden. Diese Einstellung erfolgt üblicherweise in einer Regelschleife (Regelkreis), um die Ausgangsspannung $U_{LED}$ und/oder Ausgangsstrom $I_{LED}$ auf einen gewünschten Wert zu regeln.

Während einer Einschaltzeit $t_{EIN}$ des Schalters 66 fließt der Ausgangsstrom $I_{LED}$ durch die Spule $L_{BUCK}$ 67 und durch die Last; die Diode $D_{BUCK}$ 69 sperrt. Während der Ausschaltzeit $t_{AUS}$ des Schalters 66 wird die in der Induktivität der Spule $L_{BUCK}$ 67 gespeicherte Energie abgebaut: Der Ausgangsstrom $I_{LED}$ über den Ausgang des Wandlerschaltkreises fließt weiter, nun jedoch durch die Diode $D_{BUCK}$ 69 und aus der in dem Kondensator $C_{BUCK}$ 68 gespeicherten elektrischen Energie.

Die Spule $L_{BUCK}$ 67 und der Kondensator $C_{BUCK}$ 68 bilden einen Tiefpass zweiter Ordnung. Effektiv wird die Abwärtswandlung dadurch erreicht, dass aus der Rechteckspannung der Gleichanteil herausgefiltert wird. Wie hoch dieser übrigbleibende Gleichanteil ist, kann durch das Tastverhältnis des Schalters 66, vorgegeben durch das Schaltersteuersignal 71 des Steuerschaltkreises 54, eingestellt werden.

In einer nichtlückenden Betriebsart des Abwärtswandlers (englisch Continuous Current Mode, abgekürzt CCM: kontinuierlicher Betrieb) fällt ein Strom durch die Spule $L_{BUCK}$ 67 während des gesamten Schalterperiode nie auf Null, da der Schalter 66 erneut geschlossen wird, bevor die in der Spule $L_{BUCK}$ 67 gespeicherte magnetische Energie vollständig abgebaut ist. Im Gegensatz dazu sinkt in einem lückenden Betrieb (englisch: Discontinuous Current Mode, abgekürzt DCM; diskontinuierlicher Betrieb) der Strom durch die Spule $L_{BUCK}$ 67 regelmäßig während jeder Schalterperiode auf Null. Die Schalterperiode umfasst nun zeitlich eine dritte Phase: Zu den auch im nichtlückenden Betrieb auftretenden Phasen der Energiespeicherung bei geschlossenem Schalter 66 einerseits und der Energiefreisetzung bei offenem Schalter 66 andererseits kommt eine dritte Phase ohne Stromfluss durch die Spule $L_{BUCK}$ 67, in der die Leuchtdiode 38, 39 ausschließlich aus dem Kondensator $C_{BUCK}$ 68 versorgt wird.

Ob ein kontinuierlicher oder ein lückender Betrieb vorliegt, hängt von Induktivität, Schaltfrequenz, Eingangsspannung, Ausgangsspannung $U_{LED}$ und dem fließenden Ausgangsstrom $I_{LED}$ ab. Da sich diese Parameter teilweise rasch ändern können, muss im Allgemeinen bei der Auslegung der Schaltung, insbesondere eines Regelkreises, der Übergang zwischen den beiden Betriebsarten berücksichtigt oder vermieden werden. Die beiden Betriebsarten unterscheiden sich hinsichtlich einer Steuerkennlinie, also der Abhängigkeit der Ausgangsspannung $U_{LED}$ von einem Tastverhältnis der Schalteransteuerung in dem Schaltersteuersignal 71.

Die Regelung des Ausgangsstroms $I_{LED}$ als Regelgröße erfolgt in einer Regelschleife. Die Größe des Ausgangstroms $I_{LED}$ wird von einem Messmittel erfasst. Insbesondere kann über einen in Serie zu der Leuchtdiode 38, 39 angeordneten Messwiderstand $R_{MESS}$ 70 (Shuntwiderstand) eine für den Strom $I_{LED}$ repräsentative Größe erfasst werden. Diese repräsentative Größe wird über einen Regler zur Erzeugung des Schaltersteuersignals 71 für den Schalter 66 genutzt.

Im kontinuierlichen Betriebsmodus (nichtlückender Betrieb) und im Grenzbetrieb kann ein Dimmen der Leuchtdiode 38, 39 bzw. eine Änderung der Abgabeleistung der Abwärtswandlerschaltung über eine Änderung des Schwellenwerts des Stroms $I_{LED}$ über die Spule $I_{Buck}$ 67, bei dem der Schalter 66 ausgeschaltet wird, erfolgen. Jedoch ist ein Absenken der Abschaltschwelle für sehr niedrige Dimmpegel bzw. niedrige Abgabeströme im Grenzbetrieb oft nicht beliebig möglich, da es bei kleinen Schwellenwerten zu Problemen hinsichtlich der Erfassung und Verarbeitung des geringen Stromwerts kommen kann. Für niedrige Lastströme $I_{LED}$ wird außerdem für den kontinuierlichen Betriebsmodus eine große Spule $L_{BUCK}$ 67 benötigt, wodurch die Abwärtswandlerschaltung teuer wird und der Raumbedarf der Abwärtswandlerschaltung steigt.

Im lückenden Betrieb wird ein Dimmen der Leuchtdiode 38, 39 oder das Einstellen einer gewünschten Abgabeleistung der Abwärtswandlerschaltung daher zumindest auch über eine Verkleinerung bzw. Vergrößerung einer Totzeit $t_{tot}$ erreicht. Die Totzeit $t_{tot}$ ist die Zeitdauer vom Zeitpunkt, bei dem der Strom $I_L$ über die Spule $I_{Buck}$ 67 auf Null abgesunken ist, bis zum Wiedereinschalten des Schalters 66. Ein Nachteil des diskontinuierlichen Betriebs ist, dass nach dem Ausschalten des Schalters 66, wenn der Strom $I_{LED}$ auf Null sinkt, Oszillationen (gedämpfte Schwingung) der Spannung über den Schalter auftreten, die aus einem aus der Spuleninduktivität $L_{BUCK}$ 67 und den parasitären Kapazitäten der Spule 67, der Diode 69 und des als Schalter 66 verwendeten Transistors gebildeten Schwingkreis herrühren.

Um Schaltverluste des Schalters 66 zu vermeiden, sollten solche Oszillationen beim Wählen des Wiedereinschaltzeitpunktes berücksichtigt bzw. der Wiedereinschaltzeitpunkt so gewählt werden, dass zum Wiedereinschaltzeitpunkt eine elektrische Spannung über den Schalter 66 ein Minimum aufweist. Dies bedeutet jedoch, dass das Wiedereinschalten des Schalters 66 nicht zu einem beliebigen Zeitpunkt erfolgen soll, sondern nur in diskreten Zeitabständen, insbesondere dann, wenn der Verlauf der Spannungsschwingung über dem Schalter 66 ein Minimum zeigt. Wird der Schalter 66 jedoch nicht zu dem der abzugebenden Leistung entsprechenden Zeitpunkt wieder eingeschaltet, sondern z.B. verspätet beim nächsten Spannungsminimum, weicht ein Istwert der von der Abwärtswandlerschaltung abgegebenen Leistung von der vorgegebenen Abgabeleistung (Soll-Wert) ab.

Fig. 8 gibt typische Signalverläufe der Abwärtswandlerschaltung nach Fig. 7 über der Zeit t wieder. Eine Schalterperiode $t_{periode}$ umfasst dabei die Einschaltzeit $t_{EIN}$, die Ausschaltzeitdauer $t_{AUS}$ und die Totzeit $t_{TOT.}$ Während der Einschaltzeitdauer $t_{EIN}$ ist der Schalter 66 leitend ("1") und die Diode $D_{BUCK}$ 69 sperrt ("0"). Während der Ausschaltzeitr $t_{AUS}$ sperrt der Schalter 66 ("0") der Schalter 66 und die Diode $D_{BUCK}$ 69 leitet ("1"). In der unteren Teilfigur von Fig. 8 ist der Verlauf des Laststroms $I_{LED}$ über der Zeit aufgetragen. Der Laststrom zeigt in der Totzeit $t_{TOT}$ die vorstehend angesprochenen Oszillationen.

Der an die Leuchtdiode 38, 39 abgegebene mittlere Strom $I_{mittel}$ ergibt sich zu

$$I_{mittel} = (\hat{I}_{peak} / 2) * ( (t_{EIN} + t_{AUS}) / (t_{EIN} + t_{AUS} + t_{TOT})) \tag{1}$$

mit der Spitzenwert $\hat{I}peak$ des Stroms $I_{LED}$, der Einschaltzeit $t_{EIN}$, der Ausschaltzeit $t_{AUS}$ und der Totzeit $t_{TOT}$. Während der Einschaltzeit $t_{EIN}$ fließt ein Strom $I_{LED, EIN}$ mit

$$I_{LED, EIN} = (U_V + U_{LED}) / L_{BUCK}; \tag{2}$$

mit der eingangsseitigen Versorgungsspannung $U_V$ der Abwärtswandlerschaltung, der ausgangsseitigen Spannung $U_{LED}$, die an die Leuchtdiode 38, 39 abgegeben wird, und dem Wert der Induktivität $L_{BUCK}$ 67. Während der Ausschaltzeit $t_{AUS}$ fließt ein Strom $I_{LED, AUS}$ mit

$$I_{LED, AUS} = (-U_{LED})/ L_{BUCK}; \tag{3}$$

mit der ausgangsseitigen Spannung $U_{LED}$, die an die Leuchtdiode 38, 39 abgegeben wird und dem Wert der Induktivität $L_{BUCK}$ 67. Während der Totzeit $t_{TOT}$ schwingt ein Strom $I_L$ durch die Induktivität $L_{BUCK}$ 67 mit einer Schwingfrequenz $f_{OSZ}$ in Höhe von

$$f_{OSZ} = \frac{1}{2\,\pi\,\sqrt{L_{BUCK}(C_{FET}+C_{SNUBBER})}} \tag{4}$$

mit dem Wert der Induktivität $L_{BUCK}$ 67, einer parasitären Kapazität $C_{FET}$ des Schalters 66 (FET) und einer parasitären Kapazität $C_{SNUBBER}$ einer Snubberdiode.

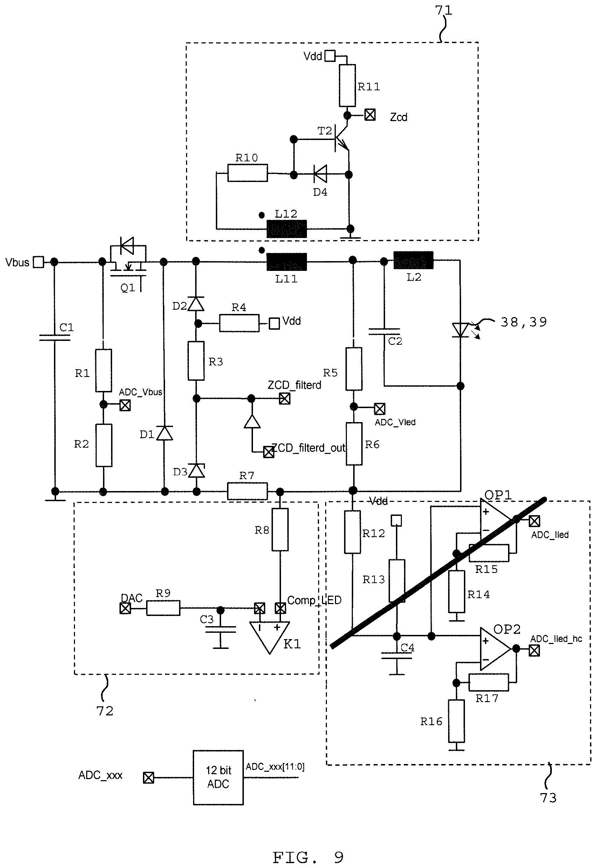

Fig. 9 zeigt ein Ausführungsbeispiel für eine Abwärtswandlerschaltung für den Betrieb von Leuchtdioden 38, 39 mit Mitteln zur Erfassung von Signalen für die Steuerung der Abwärtswandlerschaltung, Die Abwärtswandlerschaltung in Fig. 9 umfasst eine Feldeffekttransistor Q1 als Schalter 66. Die Diode D1 der dargestellten Ausführungsform könnte auch mittels eines weiteren Schalters realisiert werden. Parallel zu einem Versorgungsspannungseingang Vbus und der Lastspannungsausgang $U_{LED}$ sind jeweils Stützkondensatoren C1 und C2 angeordnet. Eine Spule L der Abwärtswandlerschaltung weist neben einer Primärwicklung L11 eine zusätzliche Sekundärwicklung L12 auf. Die Sekundärwicklung L12 ist über einen Widerstand R10 an die Basis eines Transistors T2 geführt. An einem Kollektor des Transistors T2 liegt über einen Widerstand R11 eine Versorgungsspannung Vdd an. Der Emitter des Transistors T2 ist mit Masse (Geräteerde) verbunden und zusätzlich mittels einer Diode D4 zur Basis rückgekoppelt. Eine in der Sekundärwicklung L12 induzierte Spannung ermöglicht an einem Pin $Z_{cd}$ ein ungefiltertes Signal zur Ermittlung von Nulldurchgängen des Stroms $I_{BUCK}$ durch die Primärwicklung L11 der Spule zu erfassen. Dieses erfasste Nulldurchgangssignal wird dem Steuerschaltkreis 54 zugeführt. Das Nulldurchgangssignal wird beispielsweise an einen analogen Eingang des Steuerschaltkreises 54 geführt und in dem Steuerschaltkreis 54 in einem dem analogen Eingang nachgeschalteten A/D-Wandler in ein Digitalsignal gewandelt, beispielsweise mit einer Auflösung von 12 Bit. Eine entsprechende Aufbereitung mittels A/D-Wandlung ist auch für die im Folgenden genannten Eingangssignale des Steuerschaltkreis 54 möglich.

An einem Pin ADC_Vbus wird mittels eines Spannungsteilers mit den Widerständen R1 und R2 ein die Versorgungsspannung $U_V$ an Vbus repräsentierendes Signal erfasst und an einen Eingang des Steuerschaltkreises 54 geführt. An einem Pin ADC_Vled wird über einen Spannungsteiler mit den Widerständen R5 und R6 ein die Lastspannung $U_{LED}$ repräsentierendes Signal erfasst und an einen weiteren Eingang des Steuerschaltkreises 54 geführt. Mittels des an einem Pin Comp_LED erfassten Signals wird ein Spitzenstrom $I_{peak}$ über die Spule L erfasst. Dies wird im gezeigten Fall durch Vergleich in einem Komparatorschaltkreis $K_1$ mit einem Referenzsignal erreicht. Das Referenzsignal kann zum Beispiel durch den Steuerschaltkreis 54 erzeugt und über einen D/A-Wandler des Steuerschaltkreises 54 an den Pin DAC ausgegeben werden. Der Pin DAC ist über einen Tiefpass an den invertierenden Eingang eines Operationsverstärkers des Komparators K1 gelegt, dessen nichtinvertierender Eingang mit dem Pin Comp_LED verbunden ist.

An einem Pin ZCD_filterd der Abwärtswandlerschaltung wird mittels der Dioden D2 und D3 ein Signal erfasst, das einen ersten Nulldurchgang des Spulenstroms $I_{BUCK}$ und damit auch des Laststroms $I_{LED}$ entspricht. Der erste Nulldurchgang ist der zeitlich erste Nulldurchgang des Spulenstroms $I_{BUCK}$ nach Schalten des Feldeffekttransistors Q1 (Schalters 66) von dem leitenden Zustand (Schalter geschlossen) in den nichtleitenden Zustand (Schalter offen). Dies ist in der gezeigten Ausführung nach Fig. 9 mittels Ausgabe des Signals an den Pin ZCD_filtered_out durch den Steuerschaltkreis 54 realisiert, so dass weitere Minima des Spulenstroms $I_{BUCK}$ nach einem ersten Minimum nicht zu weiteren Schaltvorgängen in einem an dem Pin ZCD_filterd anliegenden gefilterten Signal führen.

In dem in Fig. 9 gezeigten Ausführungsbeispiel ist weiter eine Erfassungsschaltung 73 zur Erfassung eines mittleren Laststroms $I_{LED}$ dargestellt. Diese Erfassungsschaltung 73 ermöglicht die Erfassung jeweils eines, den mittleren Laststrom $I_{LED}$ repräsentierenden Signals für einen Bereich höherer Lastströme an einem Pin ADC_Iled_hc und einen Bereich niedrigerer Lastströme an einem Pin ADC_Iled. In einem nicht von der in den Ansprüchen definierten Erfindung umfassten Beispiel ist diese Erfassungsschaltung für die Steuerung der Abwärtswandlerschaltung entsprechend dem im Folgenden vorgestellten Steuerverfahren nicht erforderlich. Das vorgestellte Verfahren ermöglicht daher, eine besonders kostengünstige Steuerung der Abwärtswandlerschaltung, da der Aufwand hinsichtlich Zahl der Bauelemente, dafür erforderlicher Raum und die damit verbundenen Stückkosten durch Verzicht auf die Erfassungsschaltung 73 verringert werden kann.

Ermöglicht wird dies durch eine entsprechende Nutzung der in dem Steuerschaltkreis 54 vorhandenen Zählerbausteine und ein entsprechendes Steuerungsverfahren. Ein typischer Mikrokontroller zur Verwendung als Steuerschaltkreis 54 ist zum Beispiel der integrierte Schaltkreis STM32F071RB.

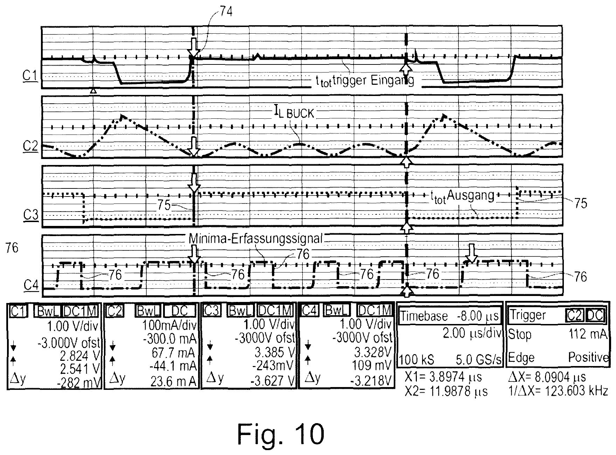

Anhand von vier in Fig. 10 gezeigten gemessenen typischen Signalverläufen der Abwärtswandlerschaltung werden einzelne Zähler einer vorteilhafte Implementierung des Verfahrens über eine Periode der getakteten Abwärtswandlerschaltung vorgestellt.

Der zweite Signalverlauf ist ein gemessener Verlauf des Stroms $I_{L\_BUCK}$ durch die Spule 67 der Abwärtswandlerschaltung. Zu einem Zeitpunkt 74 ist der Strom $I_{L\_BUCK}$ durch die Spule 67 auf Null abgeklungen und das Signal $t_{tot}$_trigger input an einem Eingang des Steuerschaltkreis 54 zeigt entsprechend der ersten Kurve eine steigende Flanke für einen Übergang von logisch Null auf logisch Eins. Bei einer steigenden Flanke des Signals $t_{tot}$_trigger input startet der Steuerschaltkreis 54 einen ersten Zähler $t_{tot\text{-}zähler}$. Das dritte Signal geht bei zählendem ersten Zähler $t_{tot\text{-}zähler}$ auf einen logisch Eins entsprechenden Pegel.

Während das dritte Signal in Fig. 10 den Wert logisch Eins zeigt, wird bei jeder fallenden Flanke 76 des Minimumerfassungssignals, dem vierten dargestellten Signal in Fig. 10, der jeweils erreichte Zählerstand des ersten Zählers $t_{tot\text{-}zähler}$ in einen Speicher geschrieben. Wenn der erste Zähler $t_{tot\text{-}zähler}$ einen Endwert, der der Totzeit $t_{tot}$ entspricht, erreicht, geht der das von dem Steuerschaltkreis 54 ausgegebene Signal $t_{tot}$ Ausgang wieder auf logisch null.

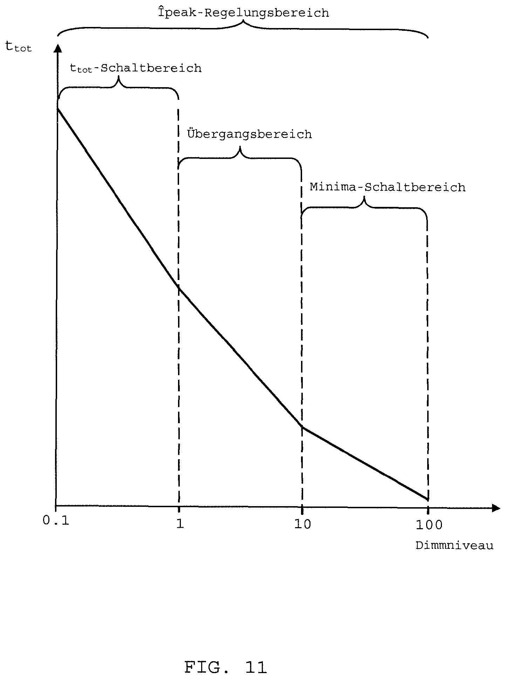

In Fig. 11 werden in einer Übersicht unterschiedliche Regelungmodi für unterschiedliche Dimmniveaus einer Ausführung der Abwärtswandlerschaltung dargestellt. Auf der Abszisse sind die unterschiedlichen Dimmniveaus in logarithmischem Maßstab aufgetragen. In Richtung der Ordinate ist die Totzeit $t_{tot}$ aufgetragen.

Die Minima des Stroms $I_{L,BUCK}$ sind lediglich für größere Stromwerte des Stroms $I_{L,BUCK}$ messtechnisch erfassbar. Daher erfolgt für höhere Dimmniveaus eine Regelung des Laststroms $I_{LED}$ mittels eines Minima-Steuerungsverfahrens (engl. valley switch mode), in dem die Regelung des Laststroms $I_{LED}$ über die Bestimmung zum Wiedereinschalten geeigneter Minima des oszillierenden Laststroms $I_{LED}$ erfolgt, um zu einem entsprechend ausgewählten Minimum den Schalter 66 zu schließen und die Einschaltzeit $t_{EIN}$ in der Schalterperiode neu zu starten. Dieser Bereich ist als dritter Bereich in Fig. 11 für hohe Dimmniveaus mit nominalen Werten zwischen 10 und 100 dargestellt.

Für kleine Dimmniveaus und entsprechend niedrige Werte des mittleren Laststroms $I_{LED}$ sind die Minima des Stroms $I_{L,BUCK}$ aufgrund der abklingenden Schwingungen nicht messtechnisch erfassbar. In diesem ersten, in Fig. 11 links angeordneten Bereich erfolgt das Schließen des Schalters 66 direkt zu dem berechneten Wert der Totzeit $t_{tot}$, um die Einschaltzeit $t_{EIN}$ der neuen Schalterperiode zu starten. Dieser erste Bereich für niedrige Dimmniveaus ist in Fig. 11 für nominale Werte des Dimmniveaus zwischen 0.1 und 1 gezeigt.

Zwischen dem ersten Bereich und dem dritten Bereich findet sich mit dem zweiten Bereich ein Übergangsbereich, in dem die Totzeit $t_{tot}$ zur Regelung des gewünschten Dimmniveaus für geringere Dimminveaus ansteigt, bis Bereiche der Totzeit $t_{tot}$ in denen keine Minima des Stroms $I_{L,BUCK}$ messbar sind, erreicht werden. Dieser dritte Bereich ist für Dimmniveaus von 1 bis 10 gezeigt.

Eine Regelung des Laststroms $I_{LED}$ durch entsprechende Regelung des Spitzenstroms $I_{peak}$ durch den Steuerschaltkreis 54 kann über alle in Fig. 11 dargestellte Bereiche für alle gezeigten Dimmniveaus erfolgen.

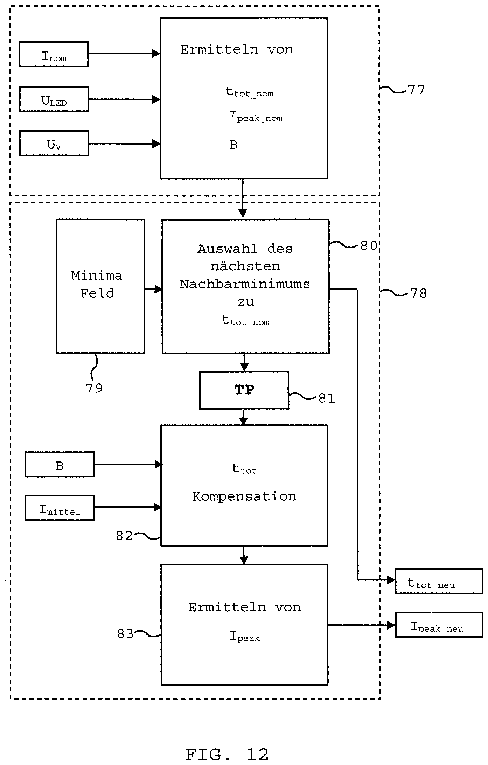

In Fig. 12 wird eine Übersicht über Funktionsblöcke für die Steuerung der Abwärtswandlerschaltung in einem Ansteuerverfahren zur Ausführung in dem Steuerschaltkreis 54 gezeigt. Dabei wird auf die mit Bezug zu Fig. 9 diskutierten Signale der Abwärtswandlerschaltung Bezug genommen. Ausgegangen wird dabei von der Einstellung eines neuen Dimmniveaus, das mittels Steuerung des Schalters 66 über einen neuen Schaltzeitpunkt mittels Schalten im Minimum des Spulenstroms $I_{L\_BUCK}$ eingestellt wird. Auf eine Regelung des mittleren Stroms $I_{mittel}$ kann bei dem in Fig. 12 gezeigten Verfahren vorteilhaft verzichtet werden.

Die im Folgenden dargestellten Module sind ganz oder teilweise in Software zur Ausführung auf einem Mikroprozessor, dem Steuerschaltkreis 54, zu implementieren. Ebenso ist allerdings eine diskrete Implementierung mittels geeigneter elektronischer Schaltungen möglich.

In einem ersten Modul 77 wird zunächst eine nominale Totzeit $t_{tot\_nom}$ ermittelt. Hierzu liest das erste Modul 77 einen nominalen Stromwert $I_{nom}$ des Laststroms $I_{LED}$, einen Wert für die Lastspannung $U_{LED}$ und einen Wert für die Versorgungsspannung $U_V$ ein. Aus diesen eingelesenen Werten werden nun die entsprechenden Werte für die nominale Totzeit $t_{tot\_nom}$, für den nominalen Spitzenstrom $I_{peak\_nom}$ und einer Rechnungsgröße B errechnet. Dabei erfolgt die Berechnung dieser Größen im ersten Modul 77 außerhalb der eigentlichen Regelschleife. Die Rechnungsgröße B und ihre Bestimmung wird nachfolgend erläutert.

Im Folgenden werden einzelne Teilaufgaben des ersten Moduls 77 kurz vorgestellt.

Zunächst ermittelt das erste Modul 77 die nominale Einschaltzeitdauer $t_{EIN\_nom}$ und $t_{AUS\_nom}$ für den Schalter 66 aus dem Zusammenhang:

$$I_{peak} = \frac{t_{EIN} \cdot (U_V - U_{LED})}{L_{BUCK}} = \frac{t_{EIN} \cdot U_{LED}}{L_{BUCK}}; \tag{5}$$

$$t_{EIN\_nom} = \frac{I_{peak} \cdot L_{BUCK}}{U_V - U_{LED}}; \tag{6}$$

$$t_{AUS\_nom} = \frac{I_{peak} \cdot L_{BUCK}}{U_{LED}}; \tag{7}$$

Anschließend wird die nominale Totzeit $t_{tot\_nom}$ ermittelt:

$$I_{mittel} = \frac{I_{peak} \cdot (t_{EIN} + t_{AUS})}{2 \cdot t_{periode}}; \tag{8}$$

$$\Rightarrow \quad t_{periode} = \frac{I_{peak} \cdot (t_{EIN} + t_{AUS})}{2 \cdot I_{mittel}}; \tag{9}$$

$$\Rightarrow \quad t_{tot\_nom} = \frac{I_{peak} \cdot (t_{EIN} + t_{AUS})}{2 \cdot I_{mittel}} - t_{EIN} - t_{AUS}; \tag{10}$$

Aus (10) ist mit (6) und (7) und unter Berücksichtigung von $I_{nom} = I_{mittel}$ die nominale Totzeit $t_{tot\_nom}$ zu

$$\Rightarrow \quad t_{tot\_nom} = \left(\frac{I_{peak}}{2\,I_{nom}} - 1\right) \cdot (t_{EIN} + t_{AUS}) = \left(\frac{I_{peak}}{2\,I_{nom}} - 1\right) \cdot \frac{I_{peak} \cdot L_{BUCK} \cdot U_V}{U_{LED} \cdot (U_V - U_{LED})}; \tag{11}$$

zu bestimmen. Die so ermittelte nominale Totzeit $t_{tot\_nom}$ wird anschließend an den Auswahlabschnitt 80 übergeben. Der Auswahlabschnitt 80 wählt ausgehend von der ermittelten nominalen Totzeit $t_{tot\_nom}$ das zeitlich nächstliegende Minimum des Stroms $I_{L\_BUCK}$, um den Schalter 66 mit einem entsprechenden Schaltersteuersignal 71 geeignet anzusteuern, insbesondere einzuschalten.

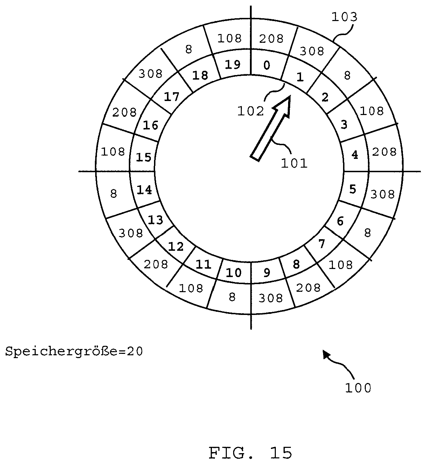

In einem zweiten Modul 78 ermittelt ein Untermodul 79 ein Feld (engl. array) von Zählerständen für Minimalwerte für den Spulenstrom $I_{L\_BUCK}$ entsprechend dem mit Bezug zu Fig. 10 diskutierten Verfahren. Das Feld von Zählerständen wird zum Beispiel in einer Speicherstruktur nach Fig. 15, einem Ringspeicher 100 gespeichert. Eine Aktualisierungsrate des Ringspeichers 100, beziehungsweise für ein in dem Ringspeicher 100 gespeichertes Feld von Zählerständen für Minima des Spulenstroms $I_{L\_BUCK}$ ist dabei mindestens größer als eine Steuerungsrate für die Ansteuerung des Schalters 66 in dem Schaltersteuersignal 71.

Der Auswahlabschnitt 80 (zweites Modul 80) wählt aus dem gespeicherten Feld von Zählerständen denjenigen mit einer geringsten Zeitdistanz zu der ermittelten nominalen Totzeit $t_{tot\_nom}$, aus. Es ist selbsterklärend, dass Zeiten und Zählerstände miteinander verglichen und ineinander umgerechnet werden können, da ein Zählerinkrement einem minimalen Zeitintervall entspricht.

Ist die ermittelte nominale Totzeit $t_{tot\_nom}$, größer als es einem größten Zählerstand entspricht, so wird statt des der nominalen Totzeit $t_{tot\_nom}$ nächstliegenden gespeicherten Zählerstand der ermittelte Nominalwert für die Totzeit $t_{tot\_nom}$ verwendet. Das Steuerungsverfahren wird stattdessen mit dem ermittelten Nominalwert für die Totzeit $t_{tot\_nom}$, fortgesetzt. Die Steuerung der abgegebenen Lichtleistung, beziehungsweise des mittleren Laststroms $I_{LED\_mittel}$ erfolgt nun im ersten, linken Schaltbereich nach Fig. 11, dem festen $t_{tot}$-Schaltbereich. Es erfolgt hier also zum Wiedereinschalten keine Auswahl eines zeitlich nächstliegenden Minimums des Stroms $I_{L\_BUCK}$ über die Spule 67.

In dem in Fig. 11 rechts dargestellten Minima-Schaltbereich gibt der Auswahlabschnitt 80 die für die eingelesene Totzeit $t_{tot\_nom}$, ausgewählte, dem zeitlich nächstliegenden Zählerstand entsprechende ausgewählte Totzeit $t_{tot}$ als neue Totzeit $t_{tot\_neu}$ aus. Der Steuerschaltkreis 54 bestimmt auf Basis der neuen Totzeit $t_{tot\_neu}$ den Einschaltzeitpunkt des Schalters 66 der Abwärtswandlerschaltung für das neue Dimmniveau.

In einem zwischen dem ersten Schaltbereich ($t_{tot}$-Schaltbereich) und dem dritten Schaltbereich (Minima-Schaltbereich) liegenden zweiten Schaltbereich (Übergangsbereich) kann die Regelung unter einer zunehmenden Berücksichtigung der Totzeit $t_{tot\_neu}$ erfolgen. Dabei sind unterschiedliche Verfahren der Gewichtung möglich und entsprechend dem gewünschten Regelverhalten auswählbar.

Der Auswahlabschnitt 80 gibt weiter die für die eingelesene Totzeit $t_{tot\_nom}$, ausgewählte, zeitlich nächstliegende ausgewählte Totzeit $t_{tot}$ an ein Kompensationsmodul 82 zur Kompensation des Spitzenstroms $I_{peak}$ aus.

Der Auswahlabschnitt 80 wählt ausgehend von der ermittelten nominalen Totzeit $t_{tot\_nom}$ das zeitlich nächstliegende Minimum des Stroms $I_{L\_BUCK}$.

Es kann zusätzlich ein Filter 81, insbesondere ausgeführt als Tiefpass, zur Kompensation eines RC-Glieds für den Spitzenstrom $I_{peak}$ zwischen dem Auswahlabschnitt 80 und dem Kompensationsmodul 82 angeordnet sein. Das RC-Glied ist nach einem Digital-Analog-Konverter (D/A-Wandler) zur Umsetzung des digital ermittelten und anschließend in einen analogen Stromwert umgesetzten Spitzenwerts $I_{peak}$ angeordnet. Das RC-Glied führt zu einer Zeitverzögerung. Das Filter 81 kann als Tiefpass mit einer Übertragungsfunktion

$$t_{tot}^{n} = \frac{\frac{1}{\alpha}t_{tot}^{n} + t_{tot\_nom}}{1+\alpha}; \qquad (12)$$

ausgebildet sein. Dabei ist $\alpha$ eine Filterkonstante und $t_{tot}^{n}$ ist die ermittelte Totzeit für einen diskreten Zeitpunkt n. $t_{tot\_nom}$ ist die nominale Totzeit.

Das Kompensationsmodul 82 (drittes Modul 82) zur Kompensation des Spitzenstroms $I_{peak}$ liest einen Wert für den mittleren Strom $I_{L\_mittel}$, sowie den in dem Auswahlabschnitt 80 ermittelten Wert für Bein. Das Kompensationsmodul 82 ermittelt aus den Werten für die ausgewählte Totzeit $t_{tot}$, dem mittleren Strom $I_{L\_mittel}$ und B einen Kompensationswert $I_{peak\_add}$ für den Spitzenwert $I_{peak\_nom}$. Der Kompensationswert $I_{peak\_add}$ für den Spitzenwert $I_{peak\_nom}$ ist dafür ausgelegt, den Spitzenstrom $I_{peak}$ anzupassen, um den Laststrom $I_{LED}$ auch während der Steuerung der Abwärtswandlerschaltung, insbesondere ihres Schalters 66 in einem Minimum des Spulenstroms $I_{L\_BUCK}$ konstant zu halten.

Im Folgenden wird die Ermittlung des Kompensationswerts $I_{peak\_add}$ für den Strom $I_{peak\_nom}$ in dem dritten Modul 82 dargestellt. Der Kompensationswert $I_{peak\_add}$ für den Strom $I_{peak\_nom}$ dient insbesondere dazu, einen Fehler aufgrund der diskreten zeitlichen Minima des Stroms $I_{L\_BUCK}$ auszugleichen (zu kompensieren), um den an das Leuchtmittel 38, 39 abgegebenen Laststrom $I_{LED}$ trotz eines diskret wechselnden Schaltzeitpunkts für das Einschalten des Schalters 66 möglichst glatt und mit lediglich geringen Abweichungen zu einem vorgegebenen Sollwert zu halten.

Ein für das Kompensationsmodul 82 geeigneter Algorithmus kann mittels folgenden Zusammenhängen erstellt werden und entsprechend ablaufen, wobei (13) einen gleichen mittleren Strom $I_{mittel}$ für unterschiedliche Perioden $t_{periode}$ eines Schaltzyklus der Abwärtswandlerschaltung aufweist:

$$I_{mittel} = \frac{I_{peak1} \cdot (t_{EIN1} + t_{AUS1})}{2 \cdot t_{periode1}} = \frac{I_{peak2} \cdot (t_{EIN2} + t_{AUS2})}{2 \cdot t_{periode2}}; \qquad (13)$$

In (13) bezeichnet der Index "1" eine erste Periode mit der Periodendauer $t_{periode1}$ und der Index "2" eine zweite Periode mit der Periodendauer $t_{periode2}$ der Abwärtswandlerschaltung.

Eine allgemeine Zeit $t_{EIN\_AUS}$ umfassend die Einschaltzeitdauer $t_{EIN}$ des Schalters 66 und die Ausschaltzeitdauer $t_{AUS}$ des Schalters 66 bis zum erstmaligen Abklingen des Stroms $I_{L\_BUCK}$ auf Null ergibt sich unter Rückgriff auf Formeln (6) und (7) zu

$$\Rightarrow t_{EIN\_AUS} = t_{EIN} + t_{AUS} = \frac{I_{peak} \cdot L_{BUCK}}{U_V - U_{LED}} + \frac{I_{peak} \cdot L_{BUCK}}{U_{LED}} = \frac{I_{peak} \cdot L_{BUCK} \cdot U_V}{(U_V - U_{LED}) \cdot U_{LED}} \; ; \tag{14}$$

Wird Formel (14) in der Formel (8) für den allgemeinen mittleren Strom $I_{mittel}$ der Abwärtswandlerschaltung verwendet, so erhält man

$$\Rightarrow I_{mittel} = \frac{I_{peak} \cdot (t_{EIN\_AUS})}{2 \cdot t_{periode}} \; ; \tag{15}$$

$$\Rightarrow I_{mittel} = \frac{I_{peak}}{2 \cdot t_{periode}} \left( \frac{I_{peak} \cdot L_{BUCK}}{U_V - U_{LED}} + \frac{I_{peak} \cdot L_{BUCK}}{U_{LED}} \right) \; ; \tag{16}$$

$$\Rightarrow I_{mittel} = \frac{I_{peak}}{2 \cdot t_{periode}} \left( \frac{I_{peak} \cdot L_{BUCK} \cdot U_V}{U_{LED} \cdot (U_V - U_{LED})} \right) \; ; \tag{17}$$

Unter Berücksichtigung von Formel (14) erhält man aus (17):

$$\Rightarrow I_{mittel} = \frac{I_{peak}^2 \cdot L_{BUCK} \cdot U_V}{2 \cdot t_{per} \cdot U_{LED} \cdot (U_V - U_{LED})} = \frac{I_{peak}^2 \cdot L_{BUCK} \cdot U_V}{2 \cdot U_{LED} \cdot (U_V - U_{LED})} \cdot \frac{1}{\left( \frac{I_{peak} \cdot L_{BUCK} \cdot U_V}{(U_V - U_{LED}) \cdot U_{LED}} \right) + t_{tot}} \; ; \tag{18}$$

Wird Gleichung (18) in mehreren Schritten umgeformt

$$\Rightarrow \frac{1}{I_{mittel}} = \frac{2 \cdot t_{periode} \cdot U_{LED} \cdot (U_V - U_{LED})}{I_{peak}^2 \cdot L_{BUCK} \cdot U_V} = \frac{2 \cdot U_{LED} \cdot (U_V - U_{LED})}{I_{peak}^2 \cdot L_{BUCK}} \cdot \left( \frac{I_{peak} \cdot L_{BUCK} \cdot U_V}{(U_V - U_{LED}) \cdot U_{LED}} + t_{tot} \right) \tag{19}$$

$$\Rightarrow \frac{I_{peak}^2 \cdot L_{BUCK} \cdot U_V}{I_{mittel} \cdot 2 \cdot U_{LED} \cdot (U_V - U_{LED})} = \left( \frac{I_{peak} \cdot L_{BUCK} \cdot U_V}{(U_V - U_{LED}) \cdot U_{LED}} + t_{tot} \right) \; ; \tag{20}$$

So erhält man eine quadratische Gleichung für den Spitzenstrom $I_{peak}$

$$\Rightarrow \frac{I_{peak}^2 \cdot L_{BUCK} \cdot U_V}{2 \cdot I_{mittel} \cdot U_{LED} \cdot (U_V - U_{LED})} - \frac{I_{peak} \cdot L_{BUCK} \cdot U_V}{(U_V - U_{LED}) \cdot U_{LED}} - t_{tot} = 0 \; ; \tag{21}$$

Gleichung (21) lässt sich in der Form

$$A \cdot I_{peak}^2 + B \cdot I_{peak} + C = 0 \; ; \tag{22}$$

<br>

mit

$$A = \frac{L_{BUCK} \cdot U_V}{2 \cdot I_{mittel} \cdot U_{LED} \cdot (U_V - U_{LED})}; \; B = -\frac{L_{BUCK} \cdot U_V}{(U_V - U_{LED}) \cdot U_{LED}}; \; C = -t_{tot}; \qquad (23)$$

schreiben. Damit ist die in dem ersten Modul 77 zu ermittelnde Rechengröße B eingeführt. Die Lösung der quadratischen Gleichung (22) lautet in allgemeiner Form

$$\Rightarrow I_{peak} = \frac{-B \pm \sqrt{B^2 - 4\,A\,C}}{2A}; \qquad (24)$$

Damit ergibt sich mit den Definitionen aus (23)

$$\Rightarrow I_{peak} = \frac{\frac{L_{BUCK} \cdot U_V}{(U_V - U_{LED}) \cdot U_{LED}} \pm \sqrt{\left(\frac{L_{BUCK} \cdot U_V}{(U_V - U_{LED}) \cdot U_{LED}}\right)^2 + \frac{2 \cdot L_{BUCK} \cdot U_V \cdot t_{tot}}{I_{mittel} \cdot U_{LED} \cdot (U_V - U_{LED})}}}{\frac{L_{BUCK} \cdot U_V}{I_{mittel} \cdot U_{LED} \cdot (U_V - U_{LED})}}; \qquad (25)$$

$$\Rightarrow \frac{I_{peak}}{I_{mittel}} = \frac{\frac{L_{BUCK} \cdot U_V}{(U_V - U_{LED}) \cdot U_{LED}} \pm \sqrt{\left(\frac{L_{BUCK} \cdot U_V}{(U_V - V_{LED}) \cdot U_{LED}}\right)^2 + \frac{2 \cdot L_{BUCK} \cdot U_V \cdot t_{tot}}{I_{mittel} \cdot U_{LED} \cdot (U_V - U_{LED})}}}{\frac{L_{BUCK} \cdot U_V}{U_{LED} \cdot (U_V - U_{LED})}}; \qquad (26)$$

Das Vorzeichen wird hier mit "+" gewählt:

$$\Rightarrow I_{peak} = \frac{B + \sqrt{(B)^2 - \frac{2 \cdot B \cdot t_{tot}}{I_{mittel}}}}{B} \cdot I_{mittel}; \qquad (27)$$

Nun kann der Parameter B als Funktion von $t_{EIN\_AUS}$ und dem Spitzenstrom $I_{peak}$ ermittelt werden:

$$t_{EIN\_AUS} = t_{EIN} + t_{AUS} = \frac{I_{peak} \cdot L_{BUCK}}{U_V - U_{LED}} + \frac{I_{peak} \cdot L_{BUCK}}{U_{LED}} = \frac{I_{peak} \cdot L_{BUCK} \cdot U_V}{(U_V - U_{LED}) \cdot U_{LED}}; \qquad (28)$$

$$B = -\frac{L_{BUCK} \cdot U_V}{(U_V - U_{LED}) \cdot U_{LED}} \Rightarrow B(t_{EIN\_AUS}, I_{peak}) = -\frac{t_{EIN\_AUS}}{I_{peak}}; \qquad (29)$$

Damit ist die in dem ersten Modul 77 zu ermittelnde Rechengröße B bestimmt. Die Berechnung des Spitzenstroms $I_{peak}$ nach Gleichung (29) wird optimiert:

$$\Rightarrow I_{peak} = I_{mittel} + \sqrt{I_{mittel}^2 - \frac{2 \cdot I_{mittel} \cdot t_{tot}}{B}} \qquad (30)$$

$$\Rightarrow I_{peak} = I_{mittel} + I_{mittel}\sqrt{1 - \frac{2 \cdot t_{tot}}{B \cdot I_{mittel}}} \; ; \tag{31}$$

Wegen (29) ist B lediglich von den konstanten Werten $L_{BUCK}$, $U_V$ und $U_{LED}$ abhängig und kann daher sofort ermittelt werden:

$$B(t_{EIN\_AUS}, I_{peak}) = -\frac{t_{EIN\_AUS}}{I_{peak}} \; ; \tag{32}$$

Ein konstanter Strom $I_{mittel}$ für unterschiedliche Perioden 1 und 2 des Schalters 66 bedeutet:

$$I_{mittel} = \frac{I_{peak1} \cdot (t_{EIN1} + t_{AUS1})}{2 \cdot t_{periode1}} = \frac{I_{peak2} \cdot (t_{EIN2} + t_{AUS2})}{2 \cdot t_{periode2}} \; ; \tag{33}$$

$$\Rightarrow I_{peak1} = \frac{I_{mittel} \cdot 2 \cdot t_{periode1}}{(t_{EIN1} + t_{AUS1})} \; ; \tag{34}$$

$$\Rightarrow I_{peak2} = \frac{I_{mittel} \cdot 2 \cdot t_{periode2}}{(t_{EIN2} + t_{AUS2})} \tag{35}$$

Damit ist der Differenzwert der Spitzenströme $I_{peak1}$ und $I_{peak2}$ für die Schalterperioden 1 und 2 zu

$$\Rightarrow I_{peak2} - I_{peak1} = \frac{I_{mittel} \cdot 2 \cdot t_{periode2}}{(t_{EIN2} + t_{AUS2})} - \frac{I_{mittel} \cdot 2 \cdot t_{periode1}}{(t_{EIN1} + t_{AUS1})} \; ; \tag{36}$$

zu bestimmen. Mit Gleichung (29) erhält man

$$\Rightarrow I_{peak2} - I_{peak1} = I_{mittel} + I_{mittel}\sqrt{1 - \frac{2 \cdot t_{tot2}}{B \cdot I_{mittel}}} - \left(I_{mittel} + I_{mittel}\sqrt{1 - \frac{2 \cdot t_{tot1}}{B \cdot I_{mittel}}}\right); \tag{37}$$

$$\Rightarrow I_{peak2} - I_{peak1} = I_{mittel}\sqrt{1 - \frac{2 \cdot t_{tot2}}{B \cdot I_{mittel}}} - I_{mittel}\sqrt{1 - \frac{2 \cdot t_{tot1}}{B \cdot I_{mittel}}} \tag{38}$$

Nun kann ein Kompensationswert $I_{peak\_add}$ für den Strom $I_{peak}$ ermittelt werden:

$$I_{peak\_add} = \text{konst.} + I_{mittel}\sqrt{1 - \frac{2 \cdot t_{tot}}{B \cdot I_{mittel}}} \; ; \tag{39}$$

Der Wert des mittleren Stroms $I_{mittel}$ kann während der Steuerung nach Minima gedimmt werden. Um dies auszugleichen, kann die Konstante konst in (39) zu $I_{mittel}$ gewählt werden:

$$I_{peak\_add} = I_{mittel} + I_{mittel}\sqrt{1 - \frac{2 \cdot t_{tot}}{B \cdot I_{mittel}}} \; ; \qquad\qquad (40)$$

Dieser ermittelte Kompensationswert $I_{peak\_add}$ wird anschließend an das Modul 83 zur Bestimmung des neuen Spitzenwerts des Stroms $I_{peak\_neu}$ übergeben. Das Modul 83 liest den ermittelten Kompensationswert $I_{peak\_add}$ und den Wert $I_{peak\_nom}$, um den neuen Spitzenwert $I_{peak\_neu}$ zu ermitteln. Das vierte Modul 83 gibt anschließend den neuen Spitzenwert $I_{peak\_neu}$ für den Strom $I_{L\_BUCK}$ aus.

Der Steuerschaltkreis 54 bestimmt auf Basis der neuen Totzeit $t_{tot\_neu}$ den neuen Spitzenwert $I_{peak\_neu}$ für den Strom $I_{L\_BUCK}$ und damit den Einschaltzeitpunkt des Schalters 66 der Abwärtswandlerschaltung für das neue Dimmniveau.

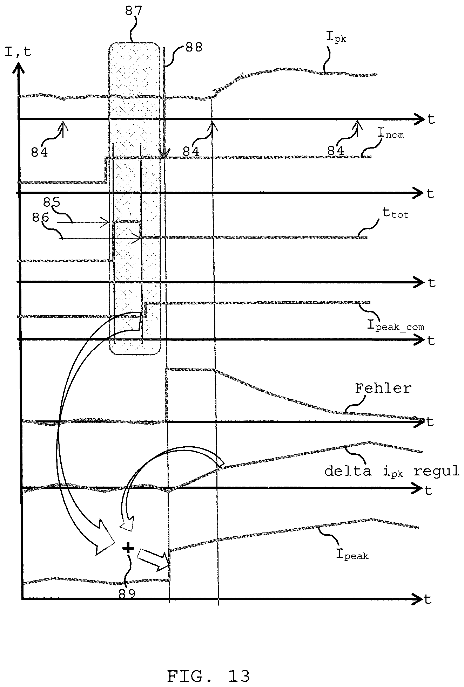

Der zeitliche Ablauf des Verfahrens zur Steuerung der Abwärtswandlerschaltung mittels der in Fig. 12 gezeigten Module, insbesondere dem ersten Modul 77, dem zweiten Modul 80, dem dritten Modul 82 und dem vierten Modul 83 wird anhand von Fig. 13 unter Berücksichtigung des zeitlichen Ablaufs erläutert. Fig. 13 zeigt eine Signalsequenz für die Ansteuerung der Abwärtswandlerschaltung bei Einstellen eines geänderten Dimmniveaus bei der Ansteuerung einer LED 38, 39.

Die Steuerung wird durch das Setzen eines neuen Zielwerts für den Laststrom $I_{LED}$ gestartet. Zunächst wird ausgehend von dem neuen Zielwert für den Laststrom $I_{LED}$ ein neuer Nominalwert $I_{nom}$ gesetzt. Der Steuerschaltkreis 54 beginnt nun einen Berechnungsphase 87. In der Berechnungsphase 87 werden die Werte für die Steuerparameter ausgehend von dem neuen Wert für den Nominalstrom $I_{nom}$ neu berechnet. Dies kann bevorzugt mit dem mit Bezug zu Fig. 12 erläuterten Verfahren erfolgen. Nach Berechnen der neuen Werte der Steuerparameter werden nach Abschluss der Berechnungsphase 87 zu einem Aktivierungszeitpunkt 88 zugleich aktiviert. Ab dem Aktivierungszeitpunkt 88 werden die neuen Werte der Steuerparameter für die Steuerung des Laststroms $I_{LED}$ gesetzt und die Abwärtswandlerschaltung wird von der Steuerschaltung 54 entsprechend auf den neuen Zielwert des Laststroms $I_{LED}$ gesteuert.

Insbesondere erfolgt die Steuerung so, dass der Steuerschaltkreis 54 nach Setzen des neuen Nominalwerts $I_{nom}$ die Berechnungsphase 87 startet. In der Berechnungsphase 87 wird auf Basis des neuen Nominalwerts $I_{nom}$ ein neuer Zielwert für den Spitzenstrom $I_{peak\_target}$ gewählt. Der Zielwert für den Spitzenstrom $I_{peak\_target}$ ist eine Funktion des Nominalwerts $I_{nom}$. Ausgehend von dem neuen Zielwert $I_{peak\_target}$ wird anschließend ein neuer Wert für die Totzeit $t_{tot}$ berechnet. Dies erfolgt zu einem ersten Zeitpunkt 85 in der Berechnungsphase 87. Ausgehend von der neuen Totzeit $t_{tot}$ wird das zeitlich nächste Minimum des Stroms $I_{L\_BUCK}$ ausgewählt. Der zu einem zweiten Zeitpunkt 86 ausgewählte Zeitpunkt des nächsten Minimum des Stroms $I_{L\_BUCK}$ ist $t_{tot\_Minimum}$. Anschließend wird der Kompensationswert $i_{peak\_add}$ für den Spitzenstromwert $I_{peak}$ ermittelt.

Die von der Steuerschaltung 54 ermittelten neuen Steuerparameter $i_{nom}$, $t_{tot\_Minimum}$ und $i_{peak\_add}$ werden nach Abschluss der Berechnungsphase 87 zu dem anschließenden Aktivierungszeitpunkt 88 gleichzeitig in einem Block aktiviert. Anschließend erfolgt die Steuerung der Abwärtswandlerschaltung mit den neuen Zielwerten und den neuen Steuerparametern. Der Steuerschaltkreis 54 führt die Steuerung mit einer Schleifenerneuerungsrate zu den Zeiten 84 aus. Die Berechnungsphase 87 ist vorzugsweise dabei so gewählt, dass die Berechnungsphase innerhalb einer Periode der Schleifenerneuerungsrate abgeschlossen ist.

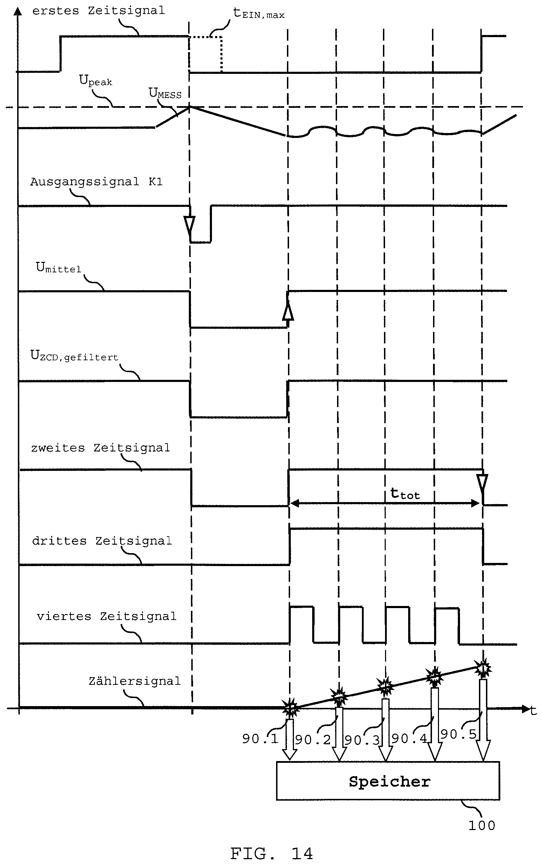

Fig. 14 zeigt ein Zeitdiagramm für Zähler des Steuerschaltkreises 54, die die Bestimmung eines Minimums für die Bestimmung eines Einschaltzeitpunkts des Schalters 66 der Abwärtswandlerschaltung bewirken. Mit Bezug zu Fig. 14 wird ein geeignetes Verfahren zur Erzeugung eines Felds von Zählerständen für Minima des Stroms $I_{L\_BUCK}$ vorgestellt. Ein entsprechendes Verfahren ist in Modul 79 der Funktionsblöcke nach Fig. 12 implementiert.

Ein Zähler_1 geht auf einen logischen Wert 1 und hält den Wert 1 an seinem Ausgang in einem ersten Zeitsignal bei, solange der Schalter 66 der Abwärtswandlerschaltung geschlossen ist. Der Zähler_1 ist während der Zeitdauer $t_{EIN}$ auf dem logischen Wert 1. Die Zeitdauer $t_{EIN}$ kann dabei variieren und erreicht dabei maximal den Wert $t_{EIN\_max}$. Eine Länge der Zeitdauer $t_{EIN}$ kann insbesondere von einem eingestellten Spitzenwert $I_{peak}$ des Strom $I_{L\_BUCK}$ abhängen. Während der Schalter 66 geschlossen ist, also der Zähler 1 den logischen Wert 1 hält, steigt eine an dem Messwiderstand $R_{MESS}$ 70 abfallende Spannung $U_{MESS}$ linear an. Die Spannung $U_{MESS}$ ist dabei proportional zu dem Laststrom $I_{LED}$. Der Laststrom $I_{LED}$ steigt, bis er den Wert des Spitzenstroms $I_{peak}$ erreicht. Dieser Spitzenstrom $I_{peak}$ ist über den Ausgang eines D/A-Wandlers und ein anschließendes RC-Glied umfassend den Widerstand R9 und den Kondensator C3 an einen Eingang des Komparators K1 gelegt, während dem anderen Eingang des Komparators K1 die Messspannung $U_{MESS}$ zugeführt wird. Damit wird am Ausgang des Komparators K1 ein Ausgangssignal Komp_1_ aus erzeugt, das bei Erreichen des Spitzenstroms $I_{peak}$ durch $I_{LED}$ für eine vorbestimmte Zeit von 1 auf 0 geht. Das Signal Komp_1_wird gesetzt, um zu verhindern, dass Nulldurchgänge des Messsignals $U_{MESS}$ in der Spannung $U_{ZCD}$ an dem Pin ZCD_gefiltert während der Zeit $t_{EIN}$ auftreten. Dazu wird die Spannung $U_{mittel}$ für die Zeit $t_{EIN}$ beginnend mit der abfallenden Flanke des Komparatorausgangssignals Komp_1_aus auf 0 gesenkt und mit der steigenden Flanke des Nulldurchgangssignals $U_{ZCD}$ wieder auf den Wert der Versorgungsspannung $U_{DD}$ angehoben.

Wenn der Zähler 1 von 1 auf den logischen Wert 0 abfällt, öffnet die Steuerschaltung 54 den Schalter 66. Der Strom $I_{LED}$ wird nun aus der in der Spule 67 gespeicherten Energie (magnetische Feldenergie) getrieben und fällt linear ab. Entsprechend fällt die Spannung $U_{MESS}$ nach Öffnen des Schalters 66 ausgehend von einem erreichten Spitzenwert $U_{peak}$ ab, bis die Spannung $U_{MESS}$ durch 0 geht. Die steigende Flanke des gefilterten Nulldurchgangsignals $U_{ZCD}$ tritt auf, sowie die abfallende Messspannung $U_{MESS}$ den Wert Null erreicht.

Wenn das gefilterte Nulldurchgangsignal $U_{ZCD}$ von 0 auf 1 wechselt, wird von einem zweiten Zähler das zweite Zeitsignal gestartet, das heißt das zweite Zeitsignal wechselt von 0 auf 1. Das zweite Zeitsignal erzeugt das invertierte Signal für die Unterdrückung der Nulldurchgänge für das Nulldurchgangssignals $U_{ZCD\_gefiltert}$.

Wenn das gefilterte Nulldurchgangsignal $U_{ZCD\_gefiltert}$ von 0 auf 1 wechselt, wird ein dritter Zähler mit einem dritten Zeitsignal gestartet, das heißt das dritte Zeitsignal wechselt von 0 auf 1. Das dritte Zeitsignal wird dazu genutzt, die Totzeit $t_{tot}$ zu erzeugen.

Wenn das gefilterte Nulldurchgangsignal $U_{ZCD, gefiltert}$ von 0 auf 1 wechselt, wird ein vierter Zähler für ein viertes Zeitsignal gestartet, das heißt, das vierte Zeitsignal wechselt von 0 auf 1. Das vierte Zeitsignal wird in Verbindung mit dem Zählersignal dazu genutzt, ein Feld der Zählerstände für Minima des Messsignals $U_{MESS}$ zu erzeugen. Das vierte Zeitsignal wechselt für jeden Nulldurchgang des Nulldurchgangssignals $U_{ZCD}$ den Wert, schaltet also von dem logischen Wert 0 auf 1, wenn das Nulldurchgangssignals $U_{ZCD}$ von einem positiven Wert auf einen negativen Wert wechselt. Wenn das Nulldurchgangssignals $U_{ZCD}$ von einem negativen Wert auf einen positiven Wert wechselt, schaltet das vierte Zeitsignal von dem logischen Wert 1 auf 0.

Das Zählersignal wird bei der steigenden Flanke des vierten Zeitsignals mit einem Zählerstand 0 gestartet und zählt linear bis zu einem Zurücksetzen des Zählersignals auf 0. Ein Zurücksetzen des Zählersignals auf 0 erfolgt zum Beispiel durch eine fallende Flanke des dritten Zeitsignals.

Bei jeder steigenden Flanke des vierten Zeitsignals wird der aktuelle Zählerstand in einen Speicher 100 geschrieben. Damit wird durch die in Fig. 14 gezeigte Abfolge von Zeitsignalen mittels den Speichervorgängen 90.1, 90.2, 90.3, 90.4 und 90.5 ein Feld von Zählerständen in dem Speicher 100 erzeugt, die ein zeitliche Folge von Minima der Messspannung $U_{MESS}$ und damit ein zeitliche Folge von Minima des Stroms $I_{L\_BUCK}$ repräsentieren.

Fig. 15 zeigt eine Speicherstruktur zur Nutzung bei der Bestimmung der zeitlichen Lage eines Minimums für die Bestimmung eines Einschaltzeitpunkts des Schalters 66 der Abwärtswandlerschaltung. Die Speicherstruktur kann in Form eines Ringspeichers 100 (Ringpufferspeichers) ausgebildet sein. In Fig. 15 ist der Ringspeicher 100 mit einer Speichergröße von 20 Speicherelementen ausgebildet. Auf die einzelnen Speicherelemente 103 kann mittels eines Speicherindex mit Indexwerten von 0 bis 19 zugegriffen werden. In Fig. 15 ist ein Zeiger 101 dargestellt, der auf ein Speicherelement 103 mit dem Speicherindexwert 1 zeigt. In dem gezeigten Speicherelement 103 mit dem Speicherindexwert 102 ist der Wert "308" gespeichert. Der Ringspeicher 100 ist vorteilhaft für die Speicherung von Zählerwerten des Zählersignals zu Zeitpunkten 90.1, 90.2, 90.3, 90.4, ... zu verwenden. Die Speicherelemente 103 enthalten dann Zählerwerte des Zählersignals, die dem Zeitpunkt eines Minimums des Stroms $I_{L\_BUCK}$ entsprechen. Ein Zählerwert kann mit einem Speicherbefehl "DMAwrite" in das Speichelement 103 geschrieben werden. Mit einem Speicherbefehl "DMAread" kann der Wert des Speichelements 103 ausgelesen werden.

Das Modul 79 kann einen Startwert des Felds der Minima und einen Endwert des Felds der Minima des Stroms $I_{L\_BUCK}$ zum Beispiel mittels folgenden Verfahrens ermitteln. Das Verfahren wird anhand des in Fig. 15 gezeigten Beispiels erläutert. Zunächst wird der aktuelle Wert des DMAindex bestimmt.

Ist der aktuelle Indexwert des Ringspeichers 100 größer als 10, so wird auf den Ringspeicher beginnend mit dem Speicherindex 102 mit dem Indexwert 0 zugegriffen. Das Speicherelement 103 für den Speicherindex 102 mit dem Wert 0 wird ausgelesen. Der Speicherindex 102 wird um 1 erhöht und das Speicherelement 103 für den Speicherindex mit dem Wert 1 wird ausgelesen. Ist der Wert des Speicherelements 103 für den Speicherindex 101 mit dem Wert 1 geringer als der Wert des Speicherelements 101 mit dem Wert 0, so ist ein Speicherelement 101 mit einem abnehmenden Wert gefunden und der Startindex des Felds der Zählerstände in dem Ringspeicher 100 ist mit 1 bestimmt. Ist der Wert des Speicherelements 103 mit dem Speicherindex 101 mit dem Wert 1 größer oder gleich dem Wert des Speicherelements 101 mit dem Wert 0, so ist noch kein Speicherelement 101 mit einem abnehmenden Wert gefunden und die Suche wird mit dem Speicherelement 102 mit einem um 1 auf 2 erhöhten Wert des Speicherindex 102 fortgesetzt, bis ein abnehmender Wert des Speicherelements gefunden ist. Damit wird der Startindex des gespeicherten Felds der Zählerstände in dem Ringspeicher 100 bestimmt.

Der Index des Endwerts des Felds der Zählerstände in dem Ringspeicher 100 wird anschließend ermittelt. Auf den Ringspeicher 100 wird beginnend mit dem Speicherindex 102 mit dem Indexwert des Startwerts zugegriffen. Das Speicherelement 103 für den Speicherindex 102 mit dem Startwert wird ausgelesen. Der Speicherindex 102 wird um 1 erhöht und das Speicherelement 103 für den Speicherindex für den Wert Startwert + 1 wird ausgelesen. Ist der Wert des Speicherelements 103 für den Speicherindex 101 mit dem Wert Startwert +1 geringer als der Wert des Speicherelements 101 mit dem Startwert als Speicherindex, so ist ein Speicherelement 101 mit einem abnehmenden Wert gefunden und der Endindex des Felds der Minima in dem Ringspeicher 100 ist mit Startwert +1 bestimmt. Ist der Wert des Speicherelements 103 für den Speicherindex 101 mit dem Wert 1 größer oder gleich dem Wert des Speicherelements 101 mit dem Startwert als Speicherindex, so ist noch kein Speicherelement 101 mit einem abnehmenden Wert gefunden und die Suche wird mit dem Speicherelement 102 mit einem um 1 auf Startwert+2 erhöhten Wert des Speicherindex 102 fortgesetzt. Dieses Vorgehen wird solange fortgesetzt, bis ein abnehmender Wert des Speicherelements 103 gefunden ist. Damit wird der Endindex des Felds der Zählerstände in dem Ringspeicher 100 bestimmt.

In dem dargestellten Zahlenbeispiel nach Fig. 15 wird ausgehend von einem aktuellen Speicherindex des Ringspeichers 100 mit dem Wert 11 der Startindex des Felds der Zählerstände zu 2 und der Endindex des Felds der Zählerstände zu 5 bestimmt.

Ist der aktuelle Indexwert des Ringspeichers 100 kleiner oder gleich 10, so wird auf den Ringspeicher beginnend mit dem Speicherindex 102 mit dem aktuellen Indexwert zugegriffen. Das Speicherelement 103 für den Speicherindex 102 mit dem aktuellen Indexwert wird ausgelesen. Der Speicherindex 102 wird um 1 erhöht und das Speicherelement 103 für den Speicherindex für den aktuellen Indexwert+1 wird ausgelesen. Ist der Wert des Speicherelements 103 für den Speicherindex 101 mit dem aktuellen Indexwert+1 geringer als der Wert des Speicherelements 101 mit dem aktuellen Indexwert, so ist ein Speicherelement 101 mit einem abnehmenden Wert gefunden und der Startindex des Felds der Zählerstände in dem Ringspeicher 100 ist mit dem aktuellen Indexwert+1 bestimmt. Ist der Wert des Speicherelements 103 für den Speicherindex 101 mit dem aktuellen Indexwert+1 größer oder gleich dem Wert des Speicherelements 101 mit dem aktuellen Indexwert, so ist noch kein Speicherelement 101 mit einem abnehmenden Wert gefunden und die Suche wird mit dem Speicherelement 102 mit einem um 1 auf den aktuellen Indexwert+2 erhöhten Wert des Speicherindex 102 fortgesetzt, bis ein abnehmender Wert des Speicherelements 103 gefunden ist. Damit wird der Startindex des Felds der Minima in dem Ringspeicher 100 bestimmt.

Der Index des Endwerts des Felds der Zählerstände für Minima in dem Ringspeicher 100 wird anschließend ermittelt. Auf den Ringspeicher 100 wird beginnend mit dem Speicherindex 102 mit dem ermittelten Indexwert des Startwerts zugegriffen. Das Speicherelement 103 für den Speicherindex 102 mit dem Startwert wird ausgelesen. Der Speicherindex 102 wird um 1 auf Startwert+1 erhöht und das Speicherelement 103 für den Speicherindex für den Wert Startwert+1 wird ausgelesen. Ist der Wert des Speicherelements 103 für den Speicherindex 101 mit dem Wert Startwert+1 geringer als der Wert des Speicherelements 101 mit dem Startwert als Speicherindex, so ist ein Speicherelement 101 mit einem abnehmenden Wert gefunden und der Endindex des Felds der Zählerstände in dem Ringspeicher 100 ist mit Startwert+1 bestimmt. Ist der Wert des Speicherelements 103 für den Speicherindex 101 mit dem Wert 1 größer oder gleich dem Wert des Speicherelements 101 mit dem Startwert als Speicherindex, so ist noch kein Speicherelement 101 mit einem abnehmenden Wert gefunden und die Suche wird mit dem Speicherelement 102 mit einem um 1 auf Startwert+2 erhöhten Wert des Speicherindex 102 fortgesetzt. Dieses Vorgehen wird solange fortgesetzt, bis ein abnehmender Wert des Speicherelements gefunden ist. Damit wird der Endindex des Felds der Zählerstände in dem Ringspeicher 100 ist bestimmt.

In dem dargestellten Zahlenbeispiel nach Fig. 15 wird ausgehend von einem aktuellen Speicherindex des Ringspeichers 100 mit dem Wert 5 der Startindex des Felds der Minima zu 6 und der Endindex des Felds der Zählerstände zu 9 bestimmt.

Um ein häufiges Umschalten zwischen unterschiedlichen Minima des Laststroms $I_{LED}$ für schnell aufeinanderfolgende Zeitpunkte zu unterdrücken, wird die Auswahl des Minimums des Laststroms $I_{LED}$ beziehungsweise des Indexwerts eines Minimums besonders vorteilhaft mit einer Hysterese implementiert.

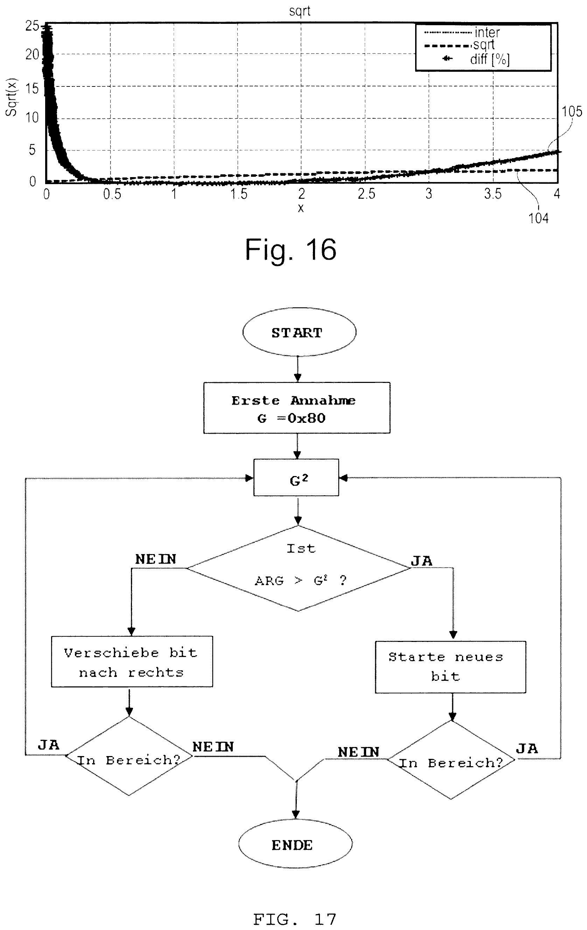

Die in dem dritten Modul 82 zur Kompensation der Totzeit $t_{tot}$ erforderliche Lösung einer quadratischen Gleichung wird vorteilhaft mittels der Nutzung von Näherungsverfahren beschleunigt. In Fig. 16 wird die Kurve 104 für ein typisches Näherungsverfahren für die Lösung einer Quadratgleichung gezeigt, das in einem Zahlenbereich zwischen 0,5 und 2 einen geringen relativen Fehlerverlauf 105 und damit gute Ergebnisse zeigt.

In Fig. 17 ist alternativ zu Fig. 16 ein Ablaufdiagramm eines weiteren Approximationsverfahrens gezeigt, dass unter der englischen Bezeichnung "Fast Integer Square Root", etwa "schnelles Integer-Quadratwurzel-Verfahren" bekannt ist.

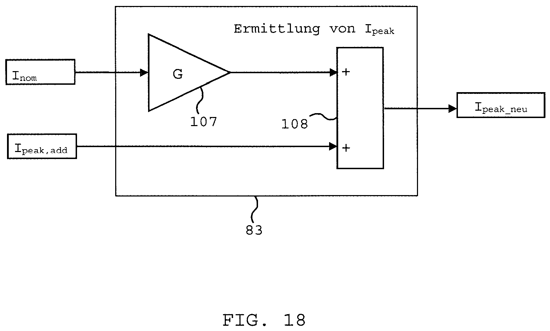

In Fig. 18 wird abschließend eine mögliche Implementierung des vierten Moduls 83 zur Bestimmung des Kompensationswert $I_{peak\_add}$ wird anschließend an das Modul 83 zur Bestimmung neuen Spitzenwerts des Stroms $I_{peak\_neu}$ des Stroms $I_{L\_BUCK}$ übergeben. Das vierte Modul 83 liest den ermittelten Kompensationswert $I_{peak\_add}$ und den Wert $I_{peak\_nom}$, um den neuen Spitzenwert $I_{peak\_neu}$ zu ermitteln. Der neue Spitzenwert $I_{peak:neu}$ kann in einem Summierglied 108 als Summe aus dem Kompensationswert $I_{peak\_add}$ und dem in einem Verstärker 107 mit einem Gewinn G multiplizierten nominellen Strom $I_{nom}$ ermittelt werden.

Das vierte Modul 83 gibt anschließend den neuen Spitzenwert $I_{peak\_neu}$ für den Strom $I_{L\_BUCK}$ aus.

Das vorstehend gezeigte Ausführungsbeispiel eines Betriebsgeräts 53 mit einem entsprechenden Steuerungsverfahren zur Ansteuerung des Schalters 66 durch den Steuerschaltkreis 54 stellt eine besonders vorteilhafte Ausführung der Erfindung unter Verwendung einer Abwärtswandlerschaltung dar. Insbesondere das erfindungsgemäße Verfahren zur Ermittlung eines LED-Stromistwerts ist auch in Verbindung mit anderen Schaltungstopologien für geschaltete Stromversorgungen vorteilhaft anwendbar.

**EP 3 646 674 B1**

**Patentansprüche**

1. Schaltungsanordnung zur Erzeugung eines einen Stromistwert repräsentierenden kombinierten Signals, wobei die Schaltungsanordnung umfasst

   Erfassungsmittel (2) zum Erfassen einer für den Strom repräsentativen Messgröße,
   einen ersten Strommesspfad (4) mit einem ersten Verstärkerschaltkreis (6) zur Verstärkung der Messgröße mit einem ersten Verstärkungsfaktor,
   einen zweiten Strommesspfad (5) mit einem zweiten Verstärkerschaltkreis (7) zur Verstärkung der Messgröße mit einem zweiten von dem ersten Verstärkungsfaktor verschiedenen Verstärkungsfaktor,
   ein Kombinationsmittel (14, 15, 19, 20, 21) ausgelegt für die Erzeugung des kombinierten Signals,
   Ausgabemittel für die Ausgabe des kombinierten Signals
   **dadurch gekennzeichnet, dass**
   das Kombinationsmittel (14, 15, 19, 20, 21) ausgelegt ist, das kombinierte Signal als eine Kombination der ersten gewichteten verstärkten Messgröße
   und der zweiten gewichteten verstärkten Messgröße
   mittels einer ersten Gewichtungsfunktion und einer zweiten Gewichtungsfunktion zu erzeugen,
   wobei die erste Gewichtungsfunktion (33) entsprechend einem vorgegebenen Stromwert einen ersten Gewichtungsfaktor für die erste verstärkte Messgröße vorgibt und die zweite Gewichtungsfunktion entsprechend dem vorgegebenen Stromwert einen zweiten Gewichtungsfaktor für die zweite verstärkte Messgröße vorgibt, und
   wobei der vorgegebenen Stromwert ein Sollwert für den zu ermittelnden Strom oder ein Dimmwert ist, und
   das Kombinationsmittel (14, 15, 19, 20, 21) eingerichtet ist, für den vorgegebenen Stromwert kleiner als ein erster Schwellenwert (35) allein die mit dem ersten Verstärkungsfaktor verstärkte Messgröße als das kombinierte Signal auszugeben, wobei der zweite Verstärkungsfaktor kleiner als der erste Verstärkungsfaktor ist.

2. Schaltungsanordnung nach Anspruch 1, **dadurch gekennzeichnet,**

   **dass** das Kombinationsmittel (14, 15, 19, 20, 21) eingerichtet ist, für den vorgegebenen Stromwert größer als oder gleich dem ersten Schwellenwert (35) und kleiner als oder gleich einem zweiten Schwellenwert (36), die Kombination der mit dem zweiten Verstärkungsfaktor verstärkten gewichteten Messgröße mit der mit dem ersten Verstärkungsfaktor verstärkten gewichteten Messgröße als das kombinierte Signal auszugeben,
   wobei der erste Gewichtungsfaktor mit zunehmendem vorgegebenen Stromwert verringert wird, insbesondere linear verringert wird, und
   der zweite Gewichtungsfaktor mit zunehmendem vorgegebenen Stromwert erhöht wird, insbesondere linear erhöht wird.

3. Schaltungsanordnung nach Anspruch 2, **dadurch gekennzeichnet,**
   **dass** das Kombinationsmittel (14, 15, 19, 20, 21) eingerichtet ist, für den vorgegebenen Stromwert größer als den zweiten Schwellenwert (36) allein die mit dem zweiten Verstärkungsfaktor verstärkte Messgröße als das kombinierte Signal auszugeben.

4. Schaltungsanordnung nach einem der Ansprüche 1 bis 3, **dadurch gekennzeichnet,**

   **dass** die Schaltungsanordnung ausgelegt ist, den Stromistwert durch zumindest eine Leuchtdiode (38, 39) zu ermitteln, und
   ferner dafür ausgelegt ist, den daraus ermittelten Stromistwert an eine Regelschleife für eine Konstantregelung des Stroms durch die zumindest eine Leuchtdiode (38, 39) auf einen vorgegebenen Sollwert auszugeben.

5. Schaltungsanordnung nach einem der Ansprüche 1 bis 4,
   **dadurch gekennzeichnet,**

   **dass** die Schaltungsanordnung eingerichtet ist, ein erstes kombiniertes Signal für einen ersten Kanal (43) eines Zweikanalsystems und ein zweites kombiniertes Signal für einen zweiten Kanal (44) eines Zweikanalsystems zu ermitteln,
   wobei der erste Kanal (43) zumindest eine Leuchtdiode (38) mit einer kaltweißen Farbtemperatur eines abgegebenen Lichts, und
   der zweite Kanal (44) zumindest eine Leuchtdiode (39) mit einer warmweißen Farbtemperatur eines abgegebenen Lichts umfasst.

6. Schaltungsanordnung nach einem der Ansprüche 1 bis 5, **dadurch gekennzeichnet,**
**dass** der erste Verstärkerschaltkreis (6) und der zweite Verstärkerschaltkreis (7) als separate diskrete Bauelemente ausgebildet sind.

7. Verfahren zur Ermittlung eines einen Stromistwert repräsentierenden kombinierten Signals mit den Schritten:

Erfassen einer für den Strom repräsentativen Messgröße (S1),
Verstärken der Messgröße in einem ersten Strommesspfad (4) mit einem ersten Verstärkungsfaktor (S2),
Verstärken der Messgröße in einem zweiten Strommesspfad (5) mit einem zweiten Verstärkungsfaktor (S3),
Erzeugen des kombinierten Signals (S4), und
Ausgeben des kombinierten Signals (S10), und
**dadurch gekennzeichnet, dass**
das Erzeugen eines kombinierten Signals mittel Kombinieren
einer ersten gewichteten verstärkten Messgröße und einer zweiten gewichteten verstärkten Messgröße (S4) erfolgt,
wobei eine erste Gewichtungsfunktion (33) entsprechend einem vorgegebenen Stromwert einen ersten Gewichtungsfaktor für die erste verstärkte Messgröße vorgibt und eine zweite Gewichtungsfunktion (34) entsprechend dem vorgegebenen Stromwert einen zweiten Gewichtungsfaktor für die zweite verstärkte Messgröße vorgibt, und
wobei der vorgegebenen Stromwert ein Sollwert für den zu ermittelnden Strom oder ein Dimmwert ist, und
wobei das Erzeugen eines kombinierten Signals für den vorgegebenen Stromwert kleiner als ein erster Schwellenwert (35) allein die mit dem ersten Verstärkungsfaktor verstärkte Messgröße verwendet, wobei der zweite Verstärkungsfaktor kleiner als der erste Verstärkungsfaktor ist.

## Claims

1. Circuit arrangement for generating a combined signal representing an actual current value, the circuit arrangement comprising

detection means (2) for detecting a measurement variable which is representative of the current,
a first current measurement path (4) having a first amplifier circuit (6) for amplifying the measurement variable by a first amplification factor,
a second current measurement path (5) having a second amplifier circuit (7) for amplifying the measurement variable by a second amplification factor which is different from the first amplification factor,
a combining means (14, 15, 19, 20, 21) designed to generate the combined signal,
output means for outputting the combined signal,
**characterized in that**
the combining means (14, 15, 19, 20, 21) is designed to generate the combined signal as a combination of the first weighted amplified measurement variable and the second weighted amplified measurement variable by means of a first weighting function and a second weighting function,
the first weighting function (33) specifying a first weighting factor for the first amplified measurement variable in accordance with a predetermined current value, and the second weighting function specifying a second weighting factor for the second amplified measurement variable in accordance with the predetermined current value, and
the predetermined current value being a target value for the current to be determined or a dimming value, and
the combining means (14, 15, 19, 20, 21) being designed to output only the measurement variable amplified by the first amplification factor as the combined signal if the predetermined current value is less than a first threshold value (35),
the second amplification factor being smaller than the first amplification factor.

2. Circuit arrangement according to claim 1, **characterized in that**

the combining means (14, 15, 19, 20, 21) is designed to output the combination of the weighted measurement variable amplified by the second amplification factor with the weighted measurement variable amplified by the first amplification factor as the combined signal if the predetermined current value is greater than or equal to the first threshold value (35) and less than or equal to a second threshold value (36),
the first weighting factor being reduced as the predetermined current value increases, in particular being reduced linearly, and
the second weighting factor being increased as the predetermined current value increases, in particular being increased linearly.

3. Circuit arrangement according to claim 2, **characterized in that**
the combining means (14, 15, 19, 20, 21) is designed to output only the measurement variable amplified by the second amplification factor as the combined signal if the predetermined current value is greater than the second threshold value (36).

4. Circuit arrangement according to any of claims 1 to 3,
**characterized in that**

the circuit arrangement is designed to determine the actual current value through at least one light-emitting diode (38, 39), and
is further designed to output the actual current value determined therefrom to a control loop for constant control of the current through the at least one light-emitting diode (38, 39) to a predetermined target value.

5. Circuit arrangement according to any of claims 1 to 4,
**characterized in that**

the circuit arrangement is designed to determine a first combined signal for a first channel (43) of a dual channel system and a second combined signal for a second channel (44) of a dual channel system,
the first channel (43) comprising at least one light-emitting diode (38) having a cold white color temperature of an emitted light, and
the second channel (44) comprising at least one light-emitting diode (39) having a warm white color temperature of an emitted light.

6. Circuit arrangement according to any of claims 1 to 5,
**characterized in that**
the first amplifier circuit (6) and the second amplifier circuit (7) are designed as separate discrete components.

7. Method for determining a combined signal representing an actual current value, comprising the steps of:

detecting a measurement value which is representative of the current (S1),
amplifying the measurement variable in a first current measurement path (4) by a first amplification factor (S2),
amplifying the measurement variable in a second current measurement path (5) by a second amplification factor (S3),
generating the combined signal (S4), and
outputting the combined signal (S10), and
**characterized in that**
a combined signal is generated by combining a first weighted amplified measurement variable and a second weighted amplified measurement variable (S4),
a first weighting function (33) specifying a first weighting factor for the first amplified measurement variable in accordance with a predetermined current value, and a second weighting function (34) specifying a second weighting factor for the second amplified measurement variable in accordance with the predetermined current value,
and
the predetermined current value being a target value for the current to be determined or a dimming value, and a combined signal being generated using only the measurement variable amplified by the first amplification factor if the predetermined current value is less than a first threshold value (35), the second amplification factor being less than the first amplification factor.

**Revendications**

1. Circuiterie pour la génération d'un signal combiné représentant une valeur réelle de courant, dans laquelle la circuiterie comprend

un moyen de détection (2) pour la détection d'une grandeur de mesure représentative du courant,

un premier chemin de mesure de courant (4) comportant un premier circuit formant amplificateur (6) pour l'amplification de la grandeur de mesure et comportant un premier facteur d'amplification,

un second chemin de mesure de courant (5) comportant un second circuit formant amplificateur (7) pour l'amplification de la grandeur de mesure et comportant un second facteur d'amplification différent du premier facteur d'amplification,

un moyen de combinaison (14, 15, 19, 20, 21) configuré pour la génération du signal combiné,

un moyen de sortie pour la sortie du signal combiné

**caractérisée en ce que**

le moyen de combinaison (14, 15, 19, 20, 21) est configuré pour générer le signal combiné sous la forme d'une combinaison de la première grandeur de mesure amplifiée pondérée et de la seconde grandeur de mesure amplifiée pondérée au moyen d'une première fonction de pondération et d'une seconde fonction de pondération, dans laquelle la première fonction de pondération (33) prédéfinit un premier facteur de pondération pour la première grandeur de mesure amplifiée en fonction d'une valeur de courant prédéfinie et la seconde fonction de pondération prédéfinit un second facteur de pondération pour la seconde grandeur de mesure amplifiée en fonction de la valeur de courant prédéfinie,

et

dans laquelle la valeur de courant prédéfinie est une valeur de consigne pour le courant à déterminer ou est une valeur de gradation, et

le moyen de combinaison (14, 15, 19, 20, 21) est configuré pour délivrer, pour la valeur de courant prédéfinie inférieure à une première valeur seuil (35), uniquement la grandeur de mesure amplifiée au moyen du premier facteur d'amplification en tant que signal combiné,

dans laquelle le second facteur d'amplification est inférieur au premier facteur d'amplification.

2. Circuiterie selon la revendication 1, **caractérisée en ce**

**que** le moyen de combinaison (14, 15, 19, 20, 21) est configuré pour délivrer, pour la valeur de courant prédéfinie supérieure ou égale à la première valeur seuil (35) et inférieure ou égale à une seconde valeur seuil (36), la combinaison de la grandeur de mesure pondérée amplifiée au moyen du second facteur d'amplification et de la grandeur de mesure pondérée amplifiée au moyen du premier facteur d'amplification en tant que signal combiné, dans laquelle le premier facteur de pondération est réduit, en particulier réduit de manière linéaire, à mesure que la valeur de courant prédéfinie progresse, et

le second facteur de pondération est augmenté, en particulier augmenté de manière linéaire, à mesure que la valeur de courant prédéfinie progresse.

3. Circuiterie selon la revendication 2, **caractérisée en ce**
**que** le moyen de combinaison (14, 15, 19, 20, 21) est configuré pour délivrer, pour la valeur de courant prédéfinie supérieure à la seconde valeur seuil (36), uniquement la grandeur de mesure amplifiée au moyen du second facteur d'amplification en tant que signal combiné.

4. Circuiterie selon l'une des revendications 1 à 3, **caractérisée en ce**

**que** la circuiterie est configurée pour déterminer la valeur réelle de courant par au moins une diode électroluminescente (38, 39), et

est en outre configurée pour délivrer la valeur réelle de courant déterminée à partir de celle-ci à une boucle de régulation pour une régulation constante du courant par l'au moins une diode électroluminescente (38, 39) à une valeur de consigne prédéfinie.

5. Circuiterie selon l'une des revendications 1 à 4, **caractérisée en ce**

**que** la circuiterie est configurée pour déterminer un premier signal combiné pour un premier canal (43) d'un système à deux canaux et pour déterminer un second signal combiné pour un second canal (44) d'un système à deux canaux,

dans laquelle le premier canal (43) comprend au moins une diode électroluminescente (38) comportant une température de couleur blanc froid d'une lumière émise, et

le second canal (44) comprend au moins une diode électroluminescente (39) comportant une température de couleur blanc chaud d'une lumière émise.

6. Circuiterie selon l'une des revendications 1 à 5, **caractérisée en ce que** le premier circuit formant amplificateur (6) et le second circuit formant amplificateur (7) sont réalisés comme des composants discrets séparés.

7. Procédé pour la détermination d'un signal combiné représentant une valeur réelle de courant, comportant les étapes consistant à :

> détecter une grandeur de mesure (S1) représentative du courant,
> amplifier la grandeur de mesure dans un premier chemin de mesure de courant (4) au moyen d'un premier facteur d'amplification (S2),
> amplifier la grandeur de mesure dans un second chemin de mesure de courant (5) au moyen d'un second facteur d'amplification (S3),
> générer le signal combiné (S4), et
> délivrer le signal combiné (S10), et
> **caractérisé en ce que**
> la génération d'un signal combiné est effectuée au moyen d'une combinaison d'une première grandeur de mesure amplifiée pondérée et d'une seconde grandeur de mesure (S4) amplifiée pondérée,
> dans lequel une première fonction de pondération (33) prédéfinit un premier facteur de pondération pour la première grandeur de mesure amplifiée en fonction d'une valeur de courant prédéfinie et une seconde fonction de pondération (34) prédéfinit un second facteur de pondération pour la seconde grandeur de mesure amplifiée en fonction de la valeur de courant prédéfinie,
> et
> dans lequel la valeur de courant prédéfinie est une valeur de consigne pour le courant à déterminer ou est une valeur de gradation, et
> dans lequel la génération d'un signal combiné pour la valeur de courant prédéfinie inférieure à une première valeur seuil (35) utilise uniquement la grandeur de mesure amplifiée au moyen du premier facteur d'amplification, dans lequel le second facteur d'amplification est inférieur au premier facteur d'amplification.

FIG. 1

Fig. 2

Ausgangsspannung Operationsverstärker $U_{AUS1}$, $U_{AUS2}$

30

3.3 V ──

31

$I_{LED}$

Gewichtungsfaktor

34

1024 ──

33

$I_{LED}$

35 ── 36

Unterer Messbereich

Übergangsbereich

Oberer Messbereich

FIG. 3

```
┌──────────────────────────┐
│    Erfassen eines        │
│ repräsentativen Signals  │ S1
└──────────────────────────┘
         │
    ┌────┴────┐
    ▼         ▼
┌──────────────────────┐   ┌──────────────────────┐
│ Verstärken mit erstem│   │ Verstärken mit zweitem│
│ Verstärkungsfaktor   │S2 │ Verstärkungsfaktor   │S3
└──────────────────────┘   └──────────────────────┘
    │                              │
    └──────────┐      ┌────────────┘
               ▼      ▼
        ┌──────────────────────┐
        │ Gewichtete Kombination│ S4
        └──────────────────────┘
                   │
                   ▼
            ◇ Aktueller Strom          JA
            < erster Schwellenwert ─────────────┐
                   S5                           │
                   │ NEIN                       │
                   ▼                            │
            ◇ Aktueller Strom      JA           │
            > zweiter Schwellenwert ──┐         │
                   S7                 │         │
                   │ NEIN            │         │
                   ▼                 │         │
        ┌──────────────────┐        │         │
        │  repr. Signal =  │        │         │
        │ gewichtete Kombination│S9 │         │
        └──────────────────┘        │         │
               │                    ▼         │
               │         ┌──────────────────┐ │
               │         │  repr. Signal =  │ │
               │         │ Ausgangsignal zweiter│ │
               │         │  Strommesspfad   │S8│
               │         └──────────────────┘ │
               │                    │         ▼
               │                    │  ┌──────────────────┐
               │                    │  │  repr. Signal =  │
               │                    │  │ Ausgangsignal erster│
               │                    │  │  Strommesspfad   │S6
               │                    │  └──────────────────┘
               │                    │         │
               └──────────┬─────────┴─────────┘
                          ▼
              ┌──────────────────────┐
              │  Ausgeben des mod.   │
              │ repräsentativen Signals│ S10
              └──────────────────────┘
```

FIG. 4

31

FIG. 5

FIG. 6

65

71

$I_V$

$Q_{BUCK}$

66

$U_V$

$L_{BUCK}$

67

$I_{LED}$

38,39

$D_{BUCK}$    69

$C_{BUCK}$    68

$U_{LED}$

$R_{MESS}$

70

LED

40,41

**FIG. 7**

Schalter

1

0

t

Diode

$t_{EIN}$    $t_{AUS}$    $t_{tot}$

1

0

t

$I_{LED}$

$\hat{I}_{peak}$

0

t

$t_{periode}$

**FIG. 8**

FIG. 9

Fig. 10

FIG. 11

FIG. 12

FIG. 13

erstes Zeitsignal

$t_{EIN,max}$

$U_{peak}$

$U_{MESS}$

Ausgangssignal K1

$U_{mittel}$

$U_{ZCD,gefiltert}$

zweites Zeitsignal

$t_{tot}$

drittes Zeitsignal

viertes Zeitsignal

Zählersignal

t

90.1  90.2  90.3  90.4  90.5

Speicher

100

FIG. 14

Speichergröße=20

FIG. 15

Fig. 16

FIG. 17

Ermittlung von $I_{peak}$

$I_{nom}$

G

107

108

$I_{peak,add}$

+

+

$I_{peak\_neu}$

83

FIG. 18

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2013027022 A1
- US 7573209 B2
- US 2005134490 A1
- US 2007152864 A1